# EUROPEAN PATENT SPECIFICATION

(11) **EP 2 950 299 B1**
(45) Date of publication and mention of the grant of the patent: **01.08.2018**
(21) Application number: 14199676.9
(22) Date of filing: 22.12.2014
(51) Int. Cl.: G09G 3/3233

(54) **Organic light emitting display device and pixel repairing method**
Organische lichtemittierende Anzeigevorrichtung und Pixelreparaturverfahren
Dispositif d'affichage électroluminescent organique et procédé de réparation de pixel

(30) Priority: 30.05.2014 KR 20140066459
(43) Date of publication of application: 02.12.2015
(73) Proprietor: LG Display Co., Ltd., Seoul 150-721 (KR)
(72) Inventor: Kim, Jeong Hwan, 131-865 Seoul (KR); Lee, Hyun Haeng, 718-704 Gyeongsangbuk-do (KR)
(74) Representative: Viering, Jentschura & Partner mbB Patent- und Rechtsanwälte

(56) References cited:
- EP-A1- 2 787 499
- JP-A- H08 129 358
- US-A1- 2004 066 146
- US-A1- 2005 041 002
- US-A1- 2007 152 567
- US-A1- 2013 050 292

## Description

### BACKGROUND

### Field of the Invention

The present invention relates to an organic light emitting display device, and more particularly, to an organic light emitting display device and a pixel repairing method, which repair hot spot errors or dark spot errors of pixels formed at an outermost line (formed on a last horizontal line) among a plurality of pixel areas emitting light by using a dummy pixel.

### Discussion of the Related Art

Organic light emitting display devices according to related art emit light from organic light emitting diodes (OLEDs) to display an image. The organic light emitting display devices include, depending on a driving type, passive matrix organic light emitting display devices and active matrix organic light emitting display devices.

A passive matrix organic light emitting display device includes a plurality of pixels being arranged in a matrix and not including thin film transistors (TFTs). In the passive matrix organic light emitting display devices, power consumption increases, and resolution is limited.

An active matrix organic light emitting display device has a plurality of TFTs respectively formed in a plurality of pixels which are arranged in a matrix type. Each of the plurality of pixels is driven according to a switching operation of a TFT and a voltage charged into a storage capacitor Cst.

The active matrix organic light emitting display devices have low power consumption and high resolution compared to the passive matrix organic light emitting display devices. An active matrix organic light emitting display device is suitable for a display device requiring a high resolution and a large area. For convenience, the present specification also refers to an active matrix organic light emitting display device is as an organic light emitting display device.

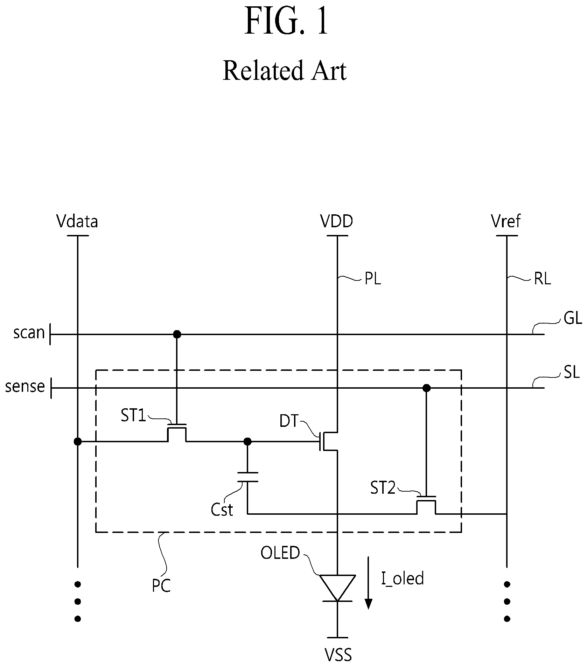

FIG. 1 is a circuit diagram for describing a pixel structure of a general organic light emitting display device. An equivalent circuit of one of a plurality of pixels which uses an external compensation method is formed in a display panel.

Each pixel of the display panel includes an OLED, which emits light with a data current Ioled applied thereto, and a pixel circuit PC which drives the OLED. Also, a plurality of lines for supplying a driving voltage and signals to the OLED and the pixel circuit PC are formed in the display panel.

Here, the pixel circuit PC includes a first switch TFT ST1, a second switching TFT ST2, a driving TFT DT, and a capacitor Cst. The plurality of lines includes a data line DL, a gate line GL, a driving voltage line PL, a sense signal line SL, and a reference voltage line RL.

The first switching TFT ST1 is turned on according to a scan signal (a gate driving signal) supplied to the gate line GL. The first switching TFT ST1 is turned on, and a data voltage Vdata supplied to the data line DL is supplied to the driving TFT DT.

The driving TFT DT is turned on with the data voltage Vdata supplied from the first switching TFT ST1. The data current Ioled flowing to the organic light emitting diode OLED is controlled with a switching time of the driving TFT DT.

When the scan signal is applied through the gate line GL, the first switching TFT ST1 is turned on. At this time, a signal from the first switching TFT ST1 is input to a gate electrode of the driving TFT DT, which is turned on. When the driving TFT DT is turned on, a driving current applied through the driving voltage line PL is input to the organic light emitting diode OLED, which emits light.

For external compensation, the sense signal line SL is formed in the same direction as that of the gate line GL. The second switching TFT ST2, which is turned on according to a sense signal applied through the sense signal line SL, is formed. The data current Ioled, which is supplied to the organic light emitting diode OLED according to the second switching TFT ST2 being turned on, is sensed by using an analog-to-digital converter (ADC) of a data driving integrated circuit (IC). A data voltage supplied to each pixel is compensated for according to a sense value of each pixel sensed by the ADC, thereby compensating for the changes in a threshold voltage "Vth" and mobility characteristic of the driving TFT DT.

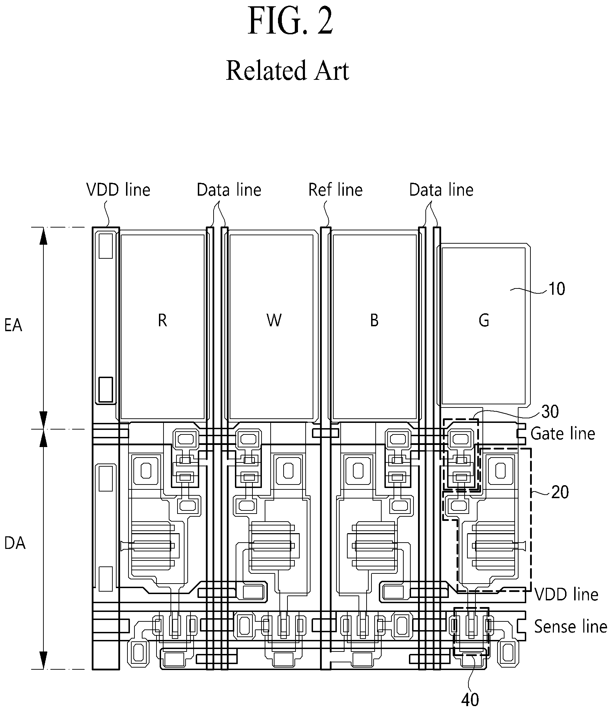

Next, FIG. 2 is a plan view of a portion of a display area of a general organic light emitting display device, and is a view illustrating one unit pixel disposed on a last horizontal line among all the pixels. An area in which a pixel circuit is formed in each pixel area is defined as a pixel circuit area CA. The pixel circuit includes a driving TFT 20, a scan TFT 30, and a sense TFT 40. An area, in which an OLED is formed, is defined as an emission area EA.

A driving voltage line (VDD line) and a data line are formed in a vertical direction, and a gate line and a sense signal line (sense line) are formed in a horizontal direction. The emission area EA is defined by an intersection of a data line and a gate line. A plurality of pixels are formed in the emission area. A red pixel, a green pixel, a blue pixel, and a white pixel constitute one unit pixel 10. A pixel circuit area CA is defined between the gate line and the sense signal line.

A source electrode of the driving TFT 20 is connected to the driving voltage line, and a drain electrode is connected to an anode electrode of the OLED. A gate electrode of the driving TFT 20 is connected to a drain electrode of the scan TFT 30. A gate electrode of the scan TFT 30 is connected to the gate line, and a source electrode is connected to the data line. A gate electrode of the sense TFT 40 is connected to the sense signal line, a drain electrode is connected to the drain electrode of the driving TFT 20, and a source electrode is connected to a reference voltage line (Ref line).

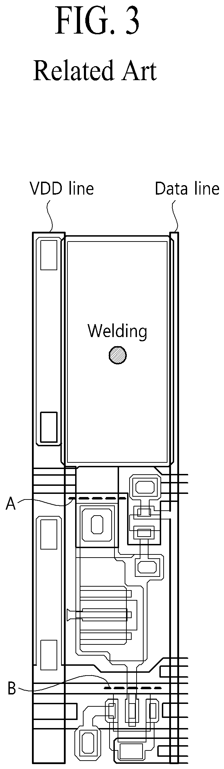

Next, FIG. 3 is a diagram illustrating that a pixel in which a hot spot error occurs is repaired and blackened. When the driving TFT 20, the scan TFT 30, or the sense TFT 40 formed in one pixel area is not driven as normal, a dark spot error occurs because a current is not applied to an OLED. Also, when the source electrode of the driving TFT 20 is short-circuited with the drain electrode (i.e., a short circuit occurs between lines and metal layers), the driving TFT 20 in each pixel is not driven as normal, and a voltage applied to the source electrode may be directly applied to the drain electrode. In this case, the driving TFT 20 is maintained in a turn-on state without being turned off, and thus, a hot spot error occurs in which the OLED continuously emits light. When a dark spot error or a hot spot error occurs in a specific pixel, it is impossible to repair a blackened pixel area, and thus, a blackened state is maintained as-is.

A whitened pixel area is cut, through laser cutting, at a point A in which the driving TFT 20 of the pixel circuit driving a whitened pixel is connected to an anode electrode of the OLED. That is, a connection between the driving TFT 20 and the anode electrode of the OLED is cut by performing laser cutting in an open area between the storage capacitor and the anode electrode of the OLED.

Moreover, a point B in which the drain electrode of the sense TFT 40 is connected to the driving TFT 20 is cut through laser cutting. Also, the anode electrode is electrically connected via a welded OLED to a cathode electrode. The welded OLED is blackened due to the welded OLED being formed in the emission area EA of a pixel in which a hot spot error occurs.

Because a dark spot error is low in visibility, a user cannot recognize a dark spot error. On the other hand, since a hot spot error is high in visibility, the user can immediately recognize a hot spot error, and thus, a whitened pixel area is blackened.

When a dark spot occurs in only one hot spot in an entire area of the display panel, an error prevents production of the display device. On the other hand, when a dark spot occurs in ten to twenty pixels in the entire area of the display panel, a pixel area in which a hot spot error occurs can be repaired by blackening the pixel area.

As described above, a hot spot is repaired by blackening the pixel area but the hot spot is not fully repaired. For this reason, there is a limitation in increasing a yield rate of products. Since millions to tens of millions of pixel areas are formed in an organic light emitting display device, a display panel in which all pixel areas have no error is difficult to manufacture. Also, in a display panel in which all pixel areas have no error, a yield rate is reduced, causing an increase in the manufacturing cost.

In particular, when dark spots occur in pixel areas which are arranged on first to N-1st horizontal lines among N numbers of horizontal lines formed in the display panel, pixel areas formed at a lower portion of the display panel are repaired, and the dark spots are repaired by receiving signals from the pixel areas formed at the lower portion.

However, when dark spots occur in pixel areas (i.e., pixel areas formed on a last horizontal line) formed at an outermost portion among pixel areas (i.e., pixel areas emitting light) formed on an Nth horizontal line in the display panel, there are no pixels in lower portions of the display panel that can provide signals to pixels in the outermost portions of the display panel.

EP 2 787 499 A1, which is considered as comprised in the state of the art only under Art. 54(3) EPC, describes an organic light-emitting display device having a plurality of emission pixels aligned in columns and rows, each of the emission pixels including an emission device and a first pixel circuit coupled to the emission device, a dummy pixel including a second pixel circuit in each column of the emission pixels, and a repair line in each column, wherein a same data signal is provided to one of the emission pixels coupled to the repair line and to the dummy pixel coupled to the repair line, and wherein the emission pixels are configured to simultaneously emit light.

US 2007/0152567 A1 describes a pixel structure electrically connected to a scan line, a data line and a power line, where the pixel structure includes a current control unit, a pixel electrode and a redundant active device. The current control unit is electrically connected to the scan line, the data line and the power line. The pixel electrode is electrically connected to the current control unit. The redundant active device is electrically connected to the pixel electrode and the current control unit, and the redundant active device is electrically insulated from the power line. US 2007/0152567 A1 further describes an organic electro-luminescence displaying unit and a repairing method thereof.

Further organic light emitting display devices are known from US 2005/041002 A1, US 2004/066146 A1, JP H08-129358 A, and US 2013/050292 A1.

### SUMMARY

Accordingly, the present invention is directed to provide an organic light emitting display device and a pixel repairing method that substantially obviate one or more problems due to limitations and disadvantages of the related art. The organic light emitting display device, and a pixel repairing method therefore, is repaired by correcting a hot sport error or dark spot error of each of pixels arranged on a last horizontal line in the organic light emitting display device.

An organic light emitting display device in accordance with various embodiments is provided according to claim 1. In one or more embodiments, the organic light emitting display device further comprises: the bridge line extending, in each of corresponding dummy pixel areas, a length of the anode electrode and overlapping, in each of corresponding pixel areas configured to emit light, an upper gate electrode of a driving TFT; and a welding part, in each of the corresponding pixel areas configured to emit light, connected to the bridge line and the upper gate electrode of the driving TFT. In one or more embodiments, when an error occurs in pixel areas formed at an outermost portion of an active area of the display device, a signal applied to anode electrodes of two pixels which are vertically adjacent to each other is shared to repair the error. In one or more embodiments, the organic light emitting display device further comprises: a color filter formed in each of corresponding pixel areas emitting light above a passivation layer and below the bridge line. In one or more embodiments, an output signal of a pixel circuit in a first dummy pixel area is supplied to, through the bridge line, an anode electrode in a first pixel area. In one or more embodiments, an anode electrode in a first pixel area is connected to an anode electrode in a first dummy pixel area through the bridge line and a metal layer of a pixel circuit in the first pixel area. In one or more embodiments, each of the plurality of pixel areas and the plurality of dummy pixel areas includes: a first pixel; a lower gate electrode formed on a substrate; a gate insulating layer formed to cover the lower gate electrode; an active layer formed on the gate insulating layer; an etch stop layer formed on the active layer; a source/drain metal layer formed on the etch stop layer; a passivation layer formed to cover the source/drain metal layer; an upper gate electrode formed on the passivation layer; a color filter formed in an opening of a pixel; a planarizing layer formed to cover the upper gate electrode and the color filter; and an anode electrode formed on the planarizing layer. In one or more embodiments, the organic light emitting display device further comprises: a welding part in each of corresponding pixel areas, the welding part connecting the bridge line to a metal layer of a pixel circuit in a first pixel area; and an anode electrode of the first pixel area, the anode electrode being connected to an anode electrode of a first dummy pixel area. In one or more embodiments, a pixel circuit in a first pixel area includes a driving thin film transistor (TFT), a scan TFT, and a sense TFT, wherein an input terminal of the driving TFT of the pixel circuit in the first pixel area is cut, wherein an output terminal of the scan TFT is cut, and wherein a portion in which the sense TFT is connected to the driving TFT is cut, and the sense TFT is short-circuited with the driving TFT. In one or more embodiments, an output signal of a pixel circuit in a first dummy pixel area is supplied to, through the bridge line, an anode electrode in the first pixel area.

In accordance with various embodiments, a method for repairing an organic light emitting display device is provided according to claim 7. In one or more embodiments, the method further comprises: supplying an output signal of a pixel circuit in a first dummy pixel area to, through the bridge line, an anode electrode in a first pixel area.

Preferred embodiments are described in the dependent claims.

A system for repairing an organic light emitting display device in accordance with another aspect of the present invention comprises: a plurality of pixel areas formed in the organic light emitting display device and including an emission area and a pixel circuit area, the plurality of pixel areas being configured to emit light; a plurality of dummy pixel areas formed adjacent to the plurality of pixel areas in the organic light emitting display device and including a non-emission area and a pixel circuit area; an anode electrode form in the plurality of dummy pixel areas; and a bridge line formed from a portion of the anode electrode and in the plurality of pixel areas. In one or more embodiments, the system further comprises: a bridge line extending, in each of corresponding dummy pixel areas, a length of an anode electrode and overlapping, in each of corresponding pixel areas configured to emit light, an upper gate electrode of the driving TFT; and a welding part, in each of the corresponding pixel areas configured to emit light, connected to the bridge line and the upper gate electrode of the driving TFT. In one or more embodiments, when an error occurs in pixel areas formed at an outermost portion of an active area of the display device, a signal applied to anode electrodes of two pixels which are vertically adjacent to each other is shared to repair the error. In one or more embodiments, the system further comprises: a color filter formed in each of corresponding pixel areas configured to emit light above a passivation layer and below the bridge line. In one or more embodiments, an output signal of the pixel circuit in a first dummy pixel area is supplied to, through the bridge line, an anode electrode in the first pixel area. In one or more embodiments, an anode electrode in the first pixel area is connected to the anode electrode in the first dummy pixel area through the bridge line and a metal layer of the pixel circuit in the first pixel area. In one or more embodiments, each of the plurality of pixel areas and the plurality of dummy pixel areas includes: a first pixel; a lower gate electrode formed on a substrate; a gate insulating layer formed to cover the lower gate electrode; an active layer formed on the gate insulating layer; an etch stop layer formed on the active layer; a source/drain metal layer formed on the etch stop layer; a passivation layer formed to cover the source/drain metal layer; an upper gate electrode formed on the passivation layer; a color filter formed in an opening of a pixel; a planarizing layer formed to cover the upper gate electrode and the color filter; and an anode electrode formed on the planarizing layer. In one or more embodiments, the system further comprises: a welding part in each of corresponding pixel areas, the welding part connecting the bridge line to a metal layer of the pixel circuit in a first pixel area; and an anode electrode of the first pixel area, the anode electrode being connected to an anode electrode of a first dummy pixel area. In one or more embodiments, the pixel circuit in a first pixel area includes a driving thin film transistor (TFT), a scan TFT, and a sense TFT, wherein an input terminal of the driving TFT of the pixel circuit in the first pixel area is cut, wherein an output terminal of the scan TFT is cut, and wherein a portion in which the sense TFT is connected to the driving TFT is cut, and the sense TFT is short-circuited with the driving TFT. In one or more embodiments, an output signal of the pixel circuit in a first dummy pixel area is supplied to, through the bridge line, an anode electrode in a first pixel area.

Other features and advantages of the present invention are clearly understood by those skilled in the art from descriptions below.

Additional advantages and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

The foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings:
FIG. 1 is a circuit diagram for describing a pixel structure of an organic light emitting display device;
FIG. 2 is a plan view of a portion of a display area of an organic light emitting display device, and illustrating one unit pixel disposed on a last horizontal line among all the pixels;
FIG. 3 is a diagram illustrating that a pixel in which a hot spot error occurs is repaired and blackened;
FIG. 4 is a diagram schematically illustrating an organic light emitting display device;
FIG. 5 is a diagram illustrating, for example, an overview of the present invention including a method of repairing hot spot errors or dark spot errors of pixels (pixels formed at a last horizontal line) formed at an outermost portion among pixel areas emitting light in an active area;
FIG. 6 is an overview of the present invention including a plan view illustrating a pixel structure of an organic light emitting display device, and is a view illustrating a welding part and a cutting part of each of pixels which are repaired;
FIG. 7 is a cross-sectional view taken along line A1-A2 of FIG. 6 according to a first embodiment of the present invention, and illustrates a cross-sectional structure of a dummy pixel area and a pixel area in which an error does not occur;
FIG. 8 is a cross-sectional view taken along line A1-A2 of FIG. 6 according to a second embodiment of the present invention, and illustrates a cross-sectional structure of a dummy pixel area and a pixel area in which a repair structure is applied to a pixel area where an error occurs; and
FIG. 9 is a cross-sectional view taken along line A1-A2 of the organic light emitting display device according to a third embodiment of the present invention, and illustrates a cross-sectional structure of a dummy pixel area and a pixel area in which a repair structure is applied to a pixel area where an error occurs.

### DETAILED DESCRIPTION OF THE INVENTION

Reference will now be made in detail to the exemplary embodiments of the present invention, examples of which are illustrated in the accompanying drawings. Wherever possible, the same reference numbers will be used throughout the drawings to refer to the same or like parts. It should be noted that like reference numerals used in the specification for each drawing to denote like elements in other drawings are used for elements wherever possible.

The terms described in the specification should be understood as follows. The singular forms "a", "an" and "the" are intended to include the plural forms as well, unless the context clearly indicates otherwise. The terms "first" and "second" are for differentiating one element from the other element, and these elements should not be limited by these terms.

It should be further understood that the terms "comprises", "comprising,", "has", "having", "includes" and/or "including", when used herein, specify the presence of stated features, integers, steps, operations, elements, and/or components, but do not preclude the presence or addition of one or more other features, integers, steps, operations, elements, components, and/or groups thereof.

In descriptions of embodiments of the present invention, when a structure is described as being formed at an upper portion/lower portion of another structure or on/under the other structure, this description should be construed as including the structure and the another structure being in contact with each other or the structure and the another structure being separated by a third structure. Hereinafter, an organic light emitting display device, and a pixel repairing method therefore, according to embodiments of the present invention will be described in detail with reference to the accompanying drawings.

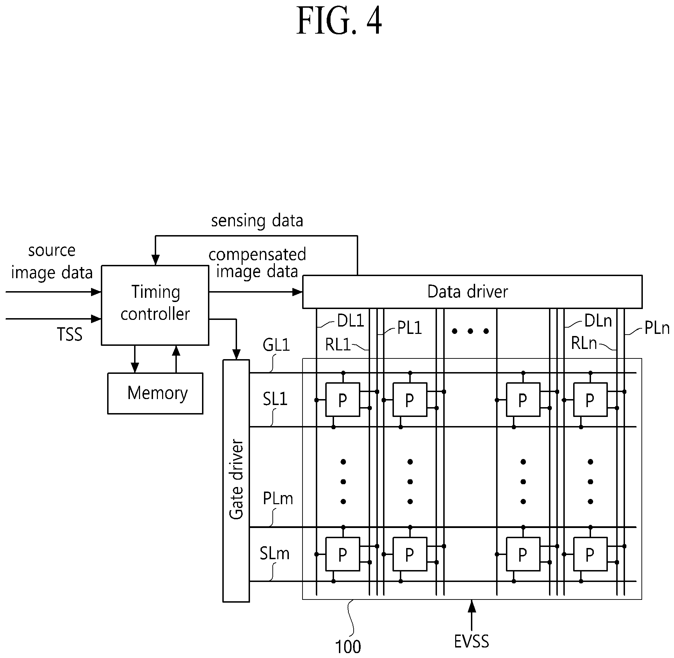

FIG. 4 is a diagram schematically illustrating an organic light emitting display device. The organic light emitting display device according to the first embodiment of the present invention includes a display panel 100 and a driving circuit unit.

The driving circuit unit includes a data driver, a gate driver, a timing controller, a memory, and a power supply. The driving circuit unit is provided on a chip-on film (COF) and a printed circuit board (PCB) on which a plurality of driving ICs are mounted. Power and a driving signal are supplied to the display panel 100 by using film-on glass (FOG).

The timing controller aligns video data in units of a frame, and supplies the aligned image data to the data driver. Also, the timing controller operates the data driver and the gate driver in a driving mode on the basis of a vertical sync signal Vsync, a horizontal sync signal Hsync, a data enable signal DE, and a clock DCLK. Also, the timing controller operates the data driver and the gate driver in a sensing mode to allow a characteristic (a threshold voltage/mobility) of a driving TFT DT formed in each of a plurality of sub-pixels to be sensed.

The gate driver operates in the driving mode and the sensing mode according to a mode control of the timing controller. In the driving mode, the gate driver generates a scan signal having a gate-on voltage level at every one horizontal period according to a gate control signal GCS supplied from the timing controller, and sequentially supplies the generated scan signal to a plurality of gate lines GL. In the sensing mode, the gate driver generates a sense signal having the gate-on voltage level, and sequentially supplies the sense signal to a plurality of sense signal lines SL.

The gate driver is connected to the plurality of gate lines GL1 to GLm, the plurality of sense signal lines SL1 to SLm, and a plurality of power lines (VDD lines) PL1 to PLn. The gate driver may be provided in an IC type, and connected to the display panel 100 through a flexible cable. As another example, when forming a transistor of each of a plurality of pixels P in a panel, the gate driver may be directly provided in a non-display area of an array substrate of the display panel 100 through the same manufacturing process.

The data driver is connected to a plurality of data lines DL1 to DLn, and operates in the display mode and the sensing mode according to control by the timing controller. The data driver converts corrected image data, supplied from the timing controller, into a data voltage Vdata, and supplies the data voltage to a data line DL.

An initial compensation voltage for compensating for a threshold voltage (Vth) of the driving TFT DT of each pixel P is stored in the memory. Also, sequential compensation data for compensating for a shift, caused by driving of the display panel 100, of the threshold voltage (Vth) of the driving TFT DT of each pixel P is stored in the memory. The timing controller may load the sequential compensation data stored in the memory to perform sequential compensation. The timing controller loads, from the memory, an initial compensation value for compensating for the shift of the threshold voltage (Vth) of the driving TFT DT, and reflects the loaded compensation value in the corrected image data.

The display panel 100 includes a plurality of OLEDs, an array substrate in which a plurality of pixel circuits for emitting light from the plurality OLEDs are formed, and an encapsulating substrate that encapsulates the plurality of OLEDs.

The display panel 100 includes an active area, in which the plurality of pixels are arranged in a matrix type and an image is displayed, and a non-display area in which a plurality of link lines and a plurality of log lines are formed.

The plurality of gate lines GL1 to GLm, the plurality of sense signal lines SL1 to SLm, the plurality of data lines DL1 to DLn, the plurality of power lines (the VDD lines) PL1 to PLn, and a plurality of reference voltage lines RL1 to RLn are formed in the active area of the array substrate, and the plurality of pixels are defined by the lines. A red (R) pixel, a green (G) pixel, a blue (B) pixel, and a white (W) pixel constitute one unit pixel.

Each of the plurality of pixels P includes an OLED and a pixel circuit that emits light from the OLED. The pixel circuit includes a driving TFT, a scan TFT, and a sense TFT.

The scan signal (a gate driving signal) is applied from the gate driver to the gate line GL. A sense signal is applied from the gate driver to the sense signal line SL.

Data voltages Vdata are applied from the data driver to the plurality of data lines DL. The data voltages Vdata may include a compensation voltage for compensating for the shift of the threshold voltage (Vth) of the driving TFT DT of each pixel P.

A display reference voltage or a sensing precharging voltage may be selectively supplied from the data driver to the reference voltage line RL. The display reference voltage is supplied to each of the plurality of reference voltage lines RL during a data charging period of each pixel. The sensing precharging voltage may be supplied to the reference voltage line RL during a sensing period in which a threshold voltage/mobility of the driving TFT DT of each pixel P is sensed.

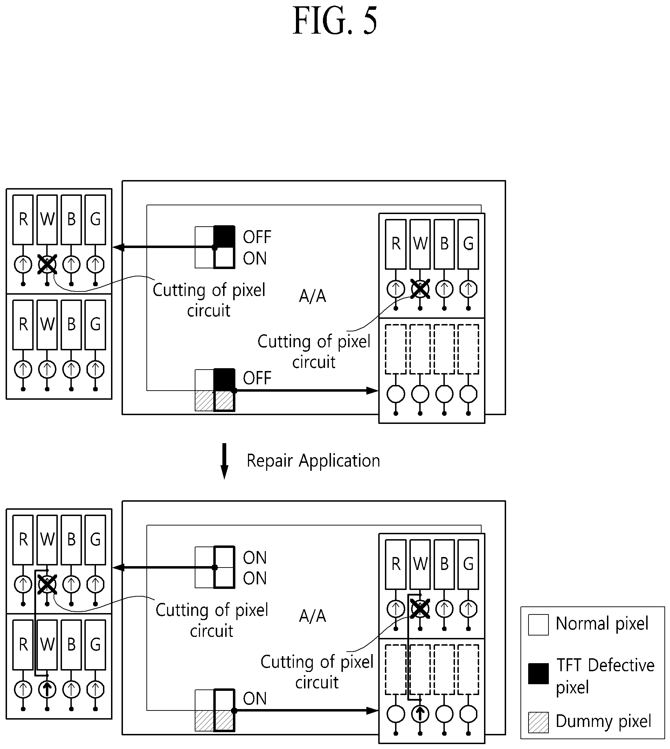

Next, FIG. 5 is a diagram illustrating, for example, an overview of the present invention including a method of repairing hot spot errors or dark spot errors of pixels (pixels formed at a last horizontal line) formed at an outermost portion among pixel areas emitting light in an active area. The organic light emitting display device according to an embodiment of the present invention, a plurality of pixel areas that emit light are formed in the active area. Also, a plurality of dummy pixels that cannot actually emit light are formed under the pixel areas that emit light.

When an error occurs in pixel areas (pixel areas formed at an outermost portion) disposed on an Nth horizontal line among N number of horizontal lines formed in the active area, repair is performed so that a signal applied to anode electrodes of two pixels which are vertically adjacent to each other is shared. That is, when an error occurs in a pixel area which is disposed on a last row among the plurality of pixel areas emitting light, repair is performed by using a dummy pixel which is formed under the pixel area in which the error occurs.

For example, since a pixel circuit in the first pixel area, which is formed on an outermost line (a last row) among the pixel areas that actually emit light, is not normally provided, a hot spot error or a dark spot error occurs in a first pixel area. In this case, an anode electrode of the OLED is disconnected from the driving TFT of the pixel circuit in the first pixel area. Also, a drain electrode of the sense TFT is disconnected from the driving TFT.

Furthermore, a signal applied to an anode electrode in a first dummy pixel area, formed under the first pixel area in which an error occurs, among a plurality of dummy pixel areas formed under the pixel areas emitting light is applied to a first pixel. To this end, the first pixel area in which the error occurs is repaired by performing a welding process.

Here, the pixel circuit in the first pixel area formed on the outermost line (the last row) among the pixel areas that actually emit light is cut, and cannot operate. Therefore, driving signals which are applied to the pixel circuit in the first pixel area are applied to a pixel circuit in the first dummy pixel area formed under the first pixel area.

An error can occur in pixel areas disposed on first to N-1st horizontal lines among the N horizontal lines formed in the active area. In this case, a pixel area in which an error occurs is repaired so that a signal applied to anode electrodes of two pixels which are vertically adjacent to each other is shared.

For example, a pixel circuit in a second pixel area formed on a second row in the active area is not normally provided, and for this reason, a hot spot error or a dark spot error can occur in a second pixel area. In this case, a driving TFT of the pixel circuit in the second pixel area is disconnected from the anode electrode of the OLED. Also, the drain electrode of the sense TFT is disconnected from the driving TFT.

The welding process is performed so that a signal, applied to an anode electrode in a third pixel area which is formed on a third row and under the second pixel area, is applied to the second pixel area in common. Therefore, the second pixel area in which an error occurs is repaired.

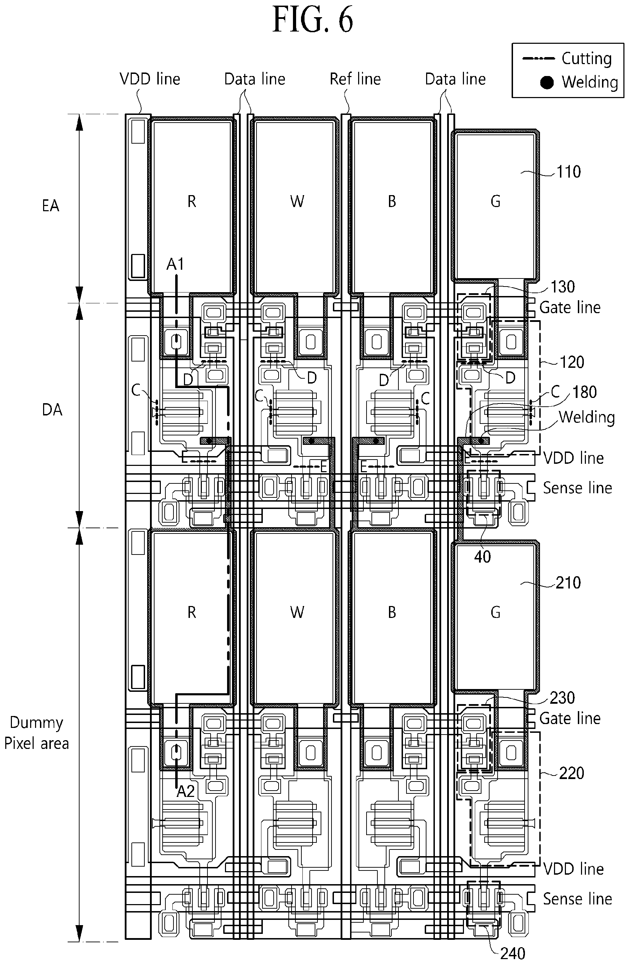

Next, FIG. 6 is an overview of the present invention including a plan view illustrating a pixel structure of an organic light emitting display device, and is a view illustrating a welding part and a cutting part of each of pixels which are repaired. The plan view illustrates a pixel area in which a hot spot error or a dark spot error occurs and which is repaired to normally emit light. An area in which a pixel circuit is provided in each pixel area is defined as a pixel circuit area CA. The pixel circuit includes a plurality of driving TFTs 120 and 220, a plurality of scan TFTs 130 and 230, and a plurality of sense TFTs 140 and 240. An area in which a plurality of OLEDs 110 and 210 are formed is defined as an emission area EA.

Here, the plurality of driving TFTs 120 and 220, the plurality of scan TFTs 130 and 230, and each of the plurality of sense TFTs 140 and 240 may be an N type or a P type transistor including a low temperature poly-silicon (LTPSL) or oxide as an active material.

Four pixel areas (red, green, blue, and white pixel areas) are formed on an outermost line (a last row) among a plurality of pixel areas emitting light. Four dummy pixel areas (red, green, blue, and white dummy pixel areas) among a plurality of dummy pixel areas are formed under the plurality of pixel areas emitting light.

The emission area EA is defined by intersection between the data line and the gate line. The plurality of pixels are formed in the emission area. The red pixel, the green pixel, the blue pixel, and the white pixel constitute one unit pixel. The pixel circuit area CA is defined between the gate line and the sense signal line.

An OLED 110 is formed in the emission area EA in four pixel areas formed on an outermost line (a last row) among the pixel areas emitting light. The driving TFT 120, the scan TFT 130, and the sense TFT 140 are formed in the pixel circuit area CA. Moreover, a dummy OLED 210 is formed in the emission area EA in four dummy pixel areas formed under the pixel areas emitting light. Because an organic emission layer EML is not formed in the dummy OLED 210, even when a signal is supplied to the dummy OLED 210, the dummy OLED 210 does not actually emit light.

A dummy driving TFT 220, a dummy scan TFT 230, and a dummy sense TFT 240 are formed in the pixel circuit area CA.

The data line and a driving voltage line (a VDD line) are formed in a vertical direction. The vertically formed driving voltage line is branched in a horizontal direction, and connected to the driving TFT 120 and the dummy driving TFT 220. A driving voltage VDD is supplied to the driving TFT 120, which is formed in a pixel circuit in a pixel area emitting light, and the dummy driving TFT 220 which is formed in a dummy pixel circuit.

The gate line and the sense signal line are formed in a horizontal direction. The gate line is connected to a gate electrode of the scan TFT 130 and a gate electrode of the dummy scan TFT 230. The scan signal is applied to the scan TFT 130 and the dummy scan TFT 230 through the gate line. The sense signal line is connected to a gate electrode of the sense TFT 140 and a gate electrode of the dummy sense TFT 240. A sense signal is applied to the sense TFT 140 and the dummy sense TFT 240 through the sense signal line.

A source electrode of each of the driving TFT 120 and the dummy driving TFT 220 is connected to the driving voltage line (the VDD line), and a drain electrode is connected to an anode electrode of the OLED 110. A gate electrode of the driving TFT 120 is connected to a drain electrode of the scan TFT 130. A gate electrode of the dummy driving TFT 220 is connected to a drain electrode of the dummy scan TFT 230. A gate electrode of each of the scan TFT 130 and the dummy scan TFT 230 is connected to the gate line, and a source electrode is connected to the data line. A gate electrode of each of the sense TFT 140 and the dummy sense TFT 240 is connected to the sense signal line.

The drain electrode of the sense TFT 140 is connected to the drain electrode of the driving TFT 120, and the gate electrode of the dummy sense TFT 240 is connected to the drain electrode of the dummy driving TFT 220. The source electrode of the sense TFT 140 and the source electrode of the dummy sense TFT 240 are connected to the reference voltage line (Ref line).

The driving TFT 120 and the scan TFT 130 or the sense TFT 140 in the pixel area, formed on the outermost line (the last line) in the pixel areas emitting light, cannot be driven normally. In this case, a current is not applied to the OLED 110, and for this reason, a dark spot error occurs. Also, the source electrode of the driving TFT 120 may be short-circuited with the drain electrode of the driving TFT 120. In this case, the driving TFT 120 is not driven normally, and a voltage applied to the source electrode is directly applied to the drain electrode. Therefore, the driving TFT 120 maintains a turn-on state without being turned off, and for this reason, a hot spot error in which the OLED 110 is continuously turned on can occur.

The organic light emitting display device and the pixel repairing method according to an embodiment of the present invention can repair a dark spot error and a hot spot error in the pixel area formed on the outermost line (the last line) in the pixel areas emitting light.

A point C, which is an input terminal of the driving TFT 120 of the pixel circuit in a pixel area where an error occurs, is first cut by a laser. Also, a point D that is an output terminal of the scan TFT 130 is cut by the laser. Also, a point E that connects the sense TFT 140 to the driving TFT 120 is cut. As described above, the pixel circuit in a pixel area where an error occurs cannot operate by cutting the points C, D and E.

A bridge line 180 is formed, and connects a metal layer, connected to an anode electrode 112 in a pixel area which is intended to emit light, to an anode electrode 212 in a dummy pixel area. In this case, a welding part is formed by a laser for the bridge line 180 to be connected to the anode electrode 112 in the pixel area.

As described above, the anode electrode 112 in a pixel area where an error occurs is connected to the anode electrode 212 in the dummy pixel area, and thus, a signal which is output from the pixel circuit in the dummy pixel area is applied to the pixel area where the error occurs.

Subsequently, a signal is applied to the pixel circuit in the dummy pixel area corresponding to the pixel area where the error occurs, and thus, the pixel circuit in the dummy pixel area operates normally. Also, a signal supplied to the anode electrode 212 of the OLED 210 of a dummy pixel is supplied to the anode electrode 112 of the OLED 110 in the pixel area where the error occurs.

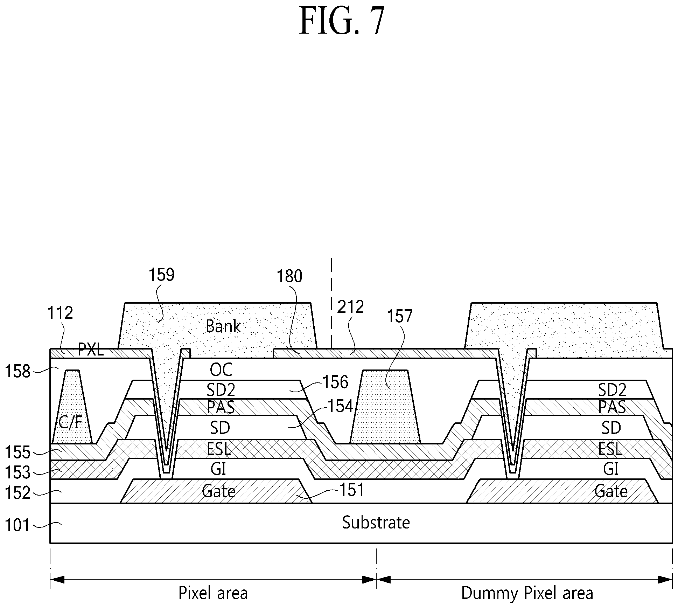

Next, FIG. 7 is a cross-sectional view taken along line A1-A2 of FIG. 6 according to a first embodiment of the present invention, and illustrates a cross-sectional structure of a dummy pixel area and a pixel area in which an error does not occur. The dummy pixel area and the pixel area include an etch stop layer (ESL)-type driving TFT. A lower gate electrode 151 is formed in the pixel area and the dummy pixel area on a substrate 101. In this case, the lower gate electrode 151 may act as a first electrode of a storage capacitor Cst.

Here, the lower gate electrode 151 may be formed of a single layer by using molybdenum (Mo), titanium (Ti), or copper (Cu). As another example, the lower gate electrode 151 may be formed in a multi-layer structure. A lower gate of a driving TFT (D-TFT) and a first electrode (a lower electrode) of the storage capacitor Cst are formed of one lower gate electrode 151. In this case, the lower gate electrode 151 is formed of the same metal as that of the scan line and the sense signal line.

A gate insulating layer (GI) 152 is formed to cover the lower gate electrode 151. The gate insulating layer (GI) 152 may be formed of a single layer formed of SiO₂ or SiNx, and may be configured with a first layer formed of SiO₂ and a second layer formed of SiNx. An active layer can be formed in a driving TFT (D-TFT) area on the gate insulating layer (GI) 152, the active layer being formed of oxide such as indium gallium oxide (IGO), indium zinc oxide (IZO), or amorphous indium-gallium zinc oxide (IGZO). The dummy pixel area and the pixel area include a cross-sectional surface of a portion in which the active layer is not formed.

An etch stop layer (ESL) 153 is formed on the gate insulating layer 152 and on the active layer. The etch stop layer 153 is formed of SiO₂. A source/drain metal layer 154 is formed on the etch stop layer 153. A source S and a drain D are formed of the source/drain metal layer 154 in the driving TFT area.

The source S and drain D of a driving TFT is formed to pass through the etch stop layer 153 in an area overlapping the active layer, on the etch stop layer 153. The source/drain metal layer 154 formed in the driving TFT area is patterned on the active layer. One side of the source/drain metal layer 154 is the drain D, and the other side is the source S.

The source/drain metal layer 154 may be a single layer formed by using molybdenum (Mo), titanium (Ti), or copper (Cu). As another example, the source/drain metal layer 154 may be formed in a multi-layer structure. A first layer may be formed of an alloy of MoTi, and a second layer may be formed of Cu. In this case, the source/drain metal layer 154 is formed of the same metal as that of the data line at the same time with a mask process. Here, the drain D of the driving TFT is connected to a VDD line.

A passivation layer (PAS) 155 is formed to cover the source/drain of the driving TFT. The passivation layer 155 is formed of SiO₂. An upper gate electrode (SD2) 156 is formed on the passivation layer 155. The upper gate electrode 156 acts as, and configures, an upper gate of the driving TFT and a second electrode (an upper electrode) of the storage capacitor Cst. The upper gate electrode 156 may be formed in a multi-layer structure. A first layer may be formed of an alloy of MoTi, and a second layer may be formed of ITO.

A color filter (C/F) 157 is formed in an opening of the pixel area, and a planarizing layer 158 is formed to cover the color filter 157 and TFTs. A bank 159 is formed at a non-emission part in the pixel area, for distinguishing a plurality of the pixel areas.

The anode electrode 112 of an OLED is formed on the planarizing layer in the opening, and although not shown, an emission layer EML is formed on the anode electrode 112. Furthermore, a cathode electrode is formed all over a substrate.

Next, Fig. 7 is a cross-sectional view taken along line A1-A2 of FIG. 6 according to a first embodiment of the present invention, and illustrates a cross-sectional structure of a dummy pixel area and a pixel area in which an error does not occur. The anode electrode 212 is formed in the dummy pixel area and extending in the pixel area emitting light, and the portion of the anode electrode 212 in the pixel area emitting light is formed to overlap the upper gate electrode 156 in the pixel area. That is, the bridge line 180 is formed from a portion of the anode electrode 212 that extends into the pixel area emitting light.

### Repair structure in a pixel area according to a second embodiment

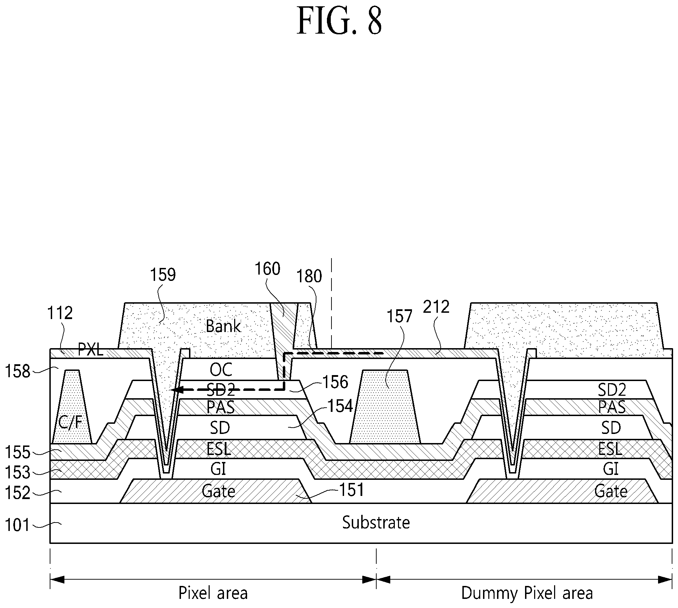

Next, FIG. 8 is a cross-sectional view taken along line A1-A2 of FIG. 6 according to a second embodiment of the present invention, and illustrates a cross-sectional structure of a dummy pixel area and a pixel area in which a repair structure is applied to a pixel area where an error occurs.

The bridge line 180 which is formed by extending a length of the anode electrode 212 in the dummy pixel area overlaps a pixel circuit which is disposed at an upper side in the pixel area (refer to FIGs. 6-8). A welding part 160 is formed by a laser for the bridge line 180 to be connected to the pixel circuit in the pixel area. In detail, the bridge line 180 which is formed by extending a length of the anode electrode 212 in the dummy pixel area overlaps an uppermost metal layer (i.e., the upper gate electrode 156) of the driving TFT 120 in the pixel area intended to emit light.

The welding part 160 is formed in an area where the bridge line 180 overlaps the gate electrode 156, so that a metal layer connected to the anode electrode 112 in the pixel area intended to emit light is connected to the anode electrode 212 in the dummy pixel area. The welding part 160 is formed at a front surface of a panel by using a laser.

By using a dummy pixel, the organic light emitting display device and the pixel repairing method according to the second embodiment of the present invention repair a hot spot error or a dark spot error in a pixel area formed on a last horizontal line among a plurality of pixel areas emitting light. As a result, a yield rate of organic light emitting display devices is increased, and manufacturing cost can be reduced.

### Repair structure in a pixel area according to a third embodiment

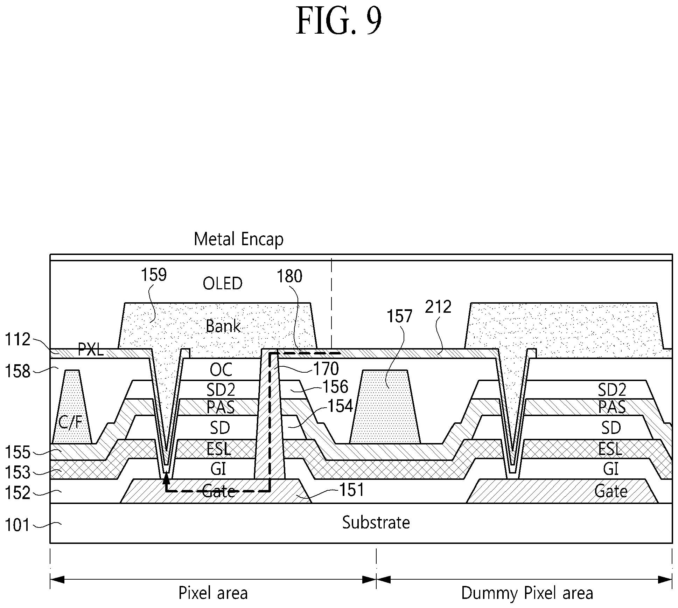

Next, FIG. 9 is a cross-sectional view taken along line A1-A2 of FIG. 6 according to a third embodiment of the present invention, and illustrates a cross-sectional structure of a dummy pixel area and a pixel area in which a repair structure is applied to a pixel area where an error occurs. The bridge line 180 which is formed by extending a length of the anode electrode 212 in the dummy pixel area overlaps a pixel circuit which is disposed at an upper side in the pixel area (refer to FIGS. 6 and 9). A welding part 170 is formed by a laser for the bridge line 180 to be connected to the pixel circuit in the pixel area.

In detail, the bridge line 180 which is formed by extending a length of the anode electrode 212 in the dummy pixel area overlaps an uppermost metal layer (i.e., the upper gate electrode 156) of the driving TFT 120 in the pixel area intended to emit light. The welding part 170 is formed in an area where the bridge line 180 overlaps the gate electrode 156, so that a metal layer connected to the anode electrode 112 in the pixel area intended to emit light is connected to the anode electrode 212 in the dummy pixel area. The welding part 170 is formed at a rear surface of a panel by using a laser.

Although the driving TFT can be the ESL-type driving TFT (refer to FIGs. 7 to 9), the present invention is not limited thereto. For example, the repair structure of the pixel (refer to FIGs. 6 to 9) may be applied to a back channel etching (BCE)-type driving TFT. The scan TFT and the sense TFT may be formed to have the same structure as that of the driving TFT (refer to FIGs. 7 to 9).

As described above, according to the embodiments of the present invention, when an error occurs in a pixel area formed at an outermost portion, an output signal of a dummy pixel is applied to an outermost pixel area in which the error occurs. Therefore, a hot spot and a dark spot in the outermost pixel area can be repaired.

In the organic light emitting display device according to the embodiments of the present invention, the pixel circuit in the first pixel area includes the driving TFT, the scan TFT, and the sense TFT. Also, an input terminal of the driving TFT of the pixel circuit in the first pixel area is cut, an output terminal of the scan TFT is cut, and a portion in which the sense TFT is connected to the driving TFT is cut. Therefore, the sense TFT is short-circuited with the driving TFT. An output signal of the pixel circuit in the first dummy pixel area is supplied to, through the bridge line, the anode electrode in the first pixel area. Among the plurality of pixel areas emitting light, the first pixel area in which the error occurs is disposed at an outermost portion. The welding part which is formed in an area where the bridge line overlaps the pixel circuit in the first pixel area, and connects the bridge line to the pixel circuit in the first pixel area.

In addition, in the organic light emitting display device according to the embodiments of the present invention, the bridge line overlaps the upper gate electrode of the driving TFT in the first pixel area, and is connected to the upper gate electrode by the welding part. The bridge line overlaps the upper gate electrode and lower gate electrode of the driving TFT in the first pixel area, and is connected to the upper gate electrode by the welding part. The anode electrode in the first pixel area is connected to the anode electrode in the first dummy pixel area through the bridge line and the metal layer of the pixel circuit in the first pixel area.

In addition, according to the embodiments of the present invention as described above, the organic light emitting display device and the pixel repairing method repair hot spot errors or dark spot errors of pixels formed at an outermost portion (formed on a last horizontal line) among a plurality of pixel areas emitting light by using a dummy pixel. Accordingly, a yield rate of organic light emitting display devices can increase, and the manufacturing cost can be reduced.

## Claims

1. An organic light emitting display device comprising:
a plurality of driving voltage lines, a plurality of data lines, and a plurality of reference voltage lines respectively formed in a vertical direction;
a plurality of gate lines and a plurality of sense signal lines respectively formed in a horizontal direction;
a plurality of pixel areas including an emission area (EA) and a pixel circuit area, the plurality of pixel areas being configured to emit light from the emission area (EA), wherein the emission area (EA) comprises a plurality of organic light emitting diodes (110) adapted to emit light, and the pixel circuit area comprises a plurality of pixel circuits for controlling emission of light from the emission area (EA), each pixel circuit comprising a driving TFT (120) configured to control supply of a data current to an associated organic light emitting diode (110), a scan TFT (130) configured to control turning on of the driving TFT (120), and a sense TFT (140) configured to control sensing of the data current supplied to the associated organic light emitting diode (110), wherein in each pixel circuit a source electrode of a driving TFT (120) is connected to a driving voltage line, a drain electrode of the driving TFT (120) is connected to an anode electrode (112) of an associated organic light emitting diode (110), a gate electrode of the driving TFT (120) is connected to a drain electrode of a scan TFT (130) of the pixel circuit, a gate electrode of the scan TFT (130) is connected to a gate line, a source electrode of the scan TFT (130) is connected to a data line, a gate electrode of a sense TFT (140) of the pixel circuit is connected to a sense signal line, a drain electrode of the sense TFT (140) is connected to a drain electrode of the driving TFT (120), a source electrode of the sense TFT (140) is connected to a reference voltage line, and a storage capacitor (Cst) is connected between the gate electrode of the driving TFT (120) and the drain electrode of the driving TFT (120);
a plurality of dummy pixel areas formed vertically adjacent to a plurality of pixel areas formed at an outermost portion of an active area of the display device on a last horizontal line, wherein each dummy pixel area comprises a non-emission area and a dummy pixel circuit area, the plurality of dummy pixel areas being adapted not to emit light, wherein the non-emission area comprises a plurality of dummy organic light emitting diodes (210) each including an anode electrode (212), wherein the dummy organic light emitting diodes (210) are formed without an organic emission layer and adapted not to emit light, and wherein the dummy pixel circuit area comprises a plurality of dummy pixel circuits, each dummy pixel circuit comprising a dummy driving TFT (220) configured to control supply of a data current to an associated dummy organic light emitting diode (210), a dummy scan TFT (230) configured to control turning on of the dummy driving TFT (220), and a dummy sense TFT (240) configured to control sensing of the data current supplied to the associated dummy organic light emitting diode (210), wherein in each dummy pixel circuit a source electrode of a dummy driving TFT (220) is connected to the driving voltage line to which the source electrode of the driving TFT (120) of an associated pixel circuit positioned vertically adjacent to the dummy pixel circuit is connected, a drain electrode of the dummy driving TFT (220) is connected to an anode electrode (212) of an associated dummy organic light emitting diode (110), a gate electrode of the dummy driving TFT (220) is connected to a drain electrode of a dummy scan TFT (230), a gate electrode of the dummy scan TFT (230) is connected to the gate line to which the gate electrode of the scan TFT (130) of the associated pixel circuit is connected, a source electrode of the dummy scan TFT (230) is connected to the data line to which the source electrode of the scan TFT (130) of the associated pixel circuit is connected, a gate electrode of a dummy sense TFT (240) is connected to the sense signal line to which the gate electrode of the sense TFT (140) of the associated pixel circuit is connected, a drain electrode of the dummy sense TFT (240) is connected to the drain electrode of the dummy driving TFT (220), a source electrode of the dummy sense TFT (240) is connected to the reference voltage line to which the source electrode of the sense TFT (140) of the associated pixel circuit is connected, and a dummy storage capacitor is connected between the gate electrode of the dummy driving TFT (220) and the drain electrode of the dummy driving TFT (220);
a gate driver configured to apply a scan signal to each scan TFT (130) and each dummy scan TFT (230) through a gate line, apply a sense signal to each sense TFT (140) and each dummy sense TFT (240) through a sense signal line, and apply a driving voltage to each driving TFT (120) and each dummy driving TFT (220) through a driving voltage line;
a data driver configured to apply a data voltage to each scan TFT (130) and each dummy scan TFT (230) through a data line, and apply a display reference voltage or a sensing precharging voltage to each sense TFT (140) and each dummy sense TFT (240) through a reference voltage line;
a timing controller configured to control an operation mode of the data driver and the gate driver;
and
a plurality of bridge lines (180) extending from respective portions of the anode electrodes (212) of the dummy organic light emitting diodes, the bridge lines (180) being arranged in the plurality of pixel areas;
wherein the bridge line corresponding to a defective pixel area on the last horizontal line connects an anode electrode (112) of an organic light emitting diode (110) in the defective pixel area to an anode electrode (212) of a corresponding dummy organic light emitting diode (210) in a corresponding dummy pixel area;
wherein in the defective pixel area, the driving TFT (120) is unconnected with the driving voltage line to which the dummy driving TFT (220) of the corresponding dummy pixel circuit is connected, the scan TFT (130) is unconnected with the driving TFT (120), and the sense TFT (140) is unconnected with the driving TFT (120).

2. The organic light emitting display device of claim 1, wherein:
each bridge line (180) extends from a length of an anode electrode (212) formed in each dummy pixel area, wherein each bridge line (180) overlaps, in each corresponding pixel area formed on the last horizontal line, a gate electrode (156) of a driving TFT (120), wherein the organic light emitting display device further comprises:
a welding part (160) in the defective pixel area connected to a corresponding bridge line (180) and the gate electrode (156) of the driving TFT (120) of the defective pixel area, wherein the welding part (160) configured to provide an electrical connection between the corresponding bridge line (180) and the gate electrode (156).

3. The organic light emitting display device of any one of claims 1 to 2, further comprising:
a color filter (157) formed in each of the pixel areas formed on the last horizontal line above a passivation layer (155) and below a corresponding bridge line (180).

4. The organic light emitting display device of any one of claims 1 to 3, wherein an anode electrode (112) in the defective pixel area of the plurality of pixel areas formed on the last horizontal line is connected to an anode electrode (212) of a corresponding dummy pixel area through a corresponding bridge line (180) and a metal layer of a pixel circuit in the defective pixel area, wherein the metal layer is connected to the anode electrode (112) in the defective pixel area.

5. The organic light emitting display device of any one of claims 1 to 2, wherein:
the driving TFT (120) of each pixel area or the dummy driving TFT (220) of each dummy pixel area comprises:
a lower gate electrode (151) formed on a substrate (101);
a gate insulating layer (152) formed to cover the lower gate electrode (151);
an active layer formed on the gate insulating layer (152);
an etch stop layer (155) formed on the active layer;
a source/drain metal layer (154) formed on the etch stop layer (153);
a passivation layer (155) formed to cover the source/drain metal layer (154); and
an upper gate electrode (156) formed on the passivation layer (155);
a color filter (157) formed in an opening of the pixel area or dummy pixel area;
a planarizing layer (158) formed to cover the upper gate electrode (156) and the color filter (157); and
an anode electrode (112, 212) formed on the planarizing layer (158).

6. The organic light emitting display device of any one of claims 1 to 3, further comprising:
a welding part (160) in the defective pixel area, the welding part (160) connecting a corresponding bridge line (180) to a metal layer (154) of a pixel circuit in the defective pixel area of the plurality of pixel areas formed on the last horizontal line to provide an electrical connection between the bridge line (180) and the metal layer (154); wherein
an anode electrode (112) of the defective pixel area is connected to an anode electrode (212) of a corresponding dummy pixel area of the plurality of dummy pixel areas via the welding part (160), the bridge line (180) and the metal layer (154).

7. A method for repairing an organic light emitting display device comprising:
a plurality of driving voltage lines, a plurality of data lines, and a plurality of reference voltage lines respectively formed in a vertical direction;
a plurality of gate lines and a plurality of sense signal lines respectively formed in a horizontal direction;
a plurality of pixel areas including an emission area (EA) and a pixel circuit area, the plurality of pixel areas being configured to emit light from the emission area (EA), wherein the emission area (EA) comprises a plurality of organic light emitting diodes (110) adapted to emit light, and the pixel circuit area comprises a plurality of pixel circuits for controlling emission of light from the emission area (EA), each pixel circuit comprising a driving TFT (120) configured to control supply of a data current to an associated organic light emitting diode (110), a scan TFT (130) configured to control turning on of the driving TFT (120), and a sense TFT (140) configured to control sensing of the data current supplied to the associated organic light emitting diode (110), wherein in each pixel circuit a source electrode of a driving TFT (120) is connected to a driving voltage line, a drain electrode of the driving TFT (120) is connected to an anode electrode (112) of an associated organic light emitting diode (110), a gate electrode of the driving TFT (120) is connected to a drain electrode of a scan TFT (130) of the pixel circuit, a gate electrode of the scan TFT (130) is connected to a gate line, a source electrode of the scan TFT (130) is connected to a data line, a gate electrode of a sense TFT (140) of the pixel circuit is connected to a sense signal line, a drain electrode of the sense TFT (140) is connected to a drain electrode of the driving TFT (120), a source electrode of the sense TFT (140) is connected to a reference voltage line, and a storage capacitor (Cst) is connected between the gate electrode of the driving TFT (120) and the drain electrode of the driving TFT (120);
a plurality of dummy pixel areas formed vertically adjacent to a plurality of pixel areas formed at an outermost portion of an active area of the display device on a last horizontal line, wherein each dummy pixel area comprises a non-emission area and a dummy pixel circuit area, the plurality of dummy pixel areas being adapted not to emit light, wherein the non-emission area comprises a plurality of dummy organic light emitting diodes (210) each including an anode electrode (212), wherein the dummy organic light emitting diodes (210) are formed without an organic emission layer and adapted not to emit light, and wherein the dummy pixel circuit area comprises a plurality of dummy pixel circuits, each dummy pixel circuit comprising a dummy driving TFT (220) configured to control supply of a data current to an associated dummy organic light emitting diode (210), a dummy scan TFT (230) configured to control turning on of the dummy driving TFT (220), and a dummy sense TFT (240) configured to control sensing of the data current supplied to the associated dummy organic light emitting diode (210), wherein in each dummy pixel circuit a source electrode of a dummy driving TFT (220) is connected to the driving voltage line to which the source electrode of the driving TFT (120) of an associated pixel circuit positioned vertically adjacent to the dummy pixel circuit is connected, a drain electrode of the dummy driving TFT (220) is connected to an anode electrode (212) of an associated dummy organic light emitting diode (110), a gate electrode of the dummy driving TFT (220) is connected to a drain electrode of a dummy scan TFT (230), a gate electrode of the dummy scan TFT (230) is connected to the gate line to which the gate electrode of the scan TFT (130) of the associated pixel circuit is connected, a source electrode of the dummy scan TFT (230) is connected to the data line to which the source electrode of the scan TFT (130) of the associated pixel circuit is connected, a gate electrode of a dummy sense TFT (240) is connected to the sense signal line to which the gate electrode of the sense TFT (140) of the associated pixel circuit is connected, a drain electrode of the dummy sense TFT (240) is connected to the drain electrode of the dummy driving TFT (220), a source electrode of the dummy sense TFT (240) is connected to the reference voltage line to which the source electrode of the sense TFT (140) of the associated pixel circuit is connected, and a dummy storage capacitor is connected between the gate electrode of the dummy driving TFT (220) and the drain electrode of the dummy driving TFT (220);
a gate driver configured to apply a scan signal to each scan TFT (130) and each dummy scan TFT (230) through a gate line, apply a sense signal to each sense TFT (140) and each dummy sense TFT (240) through a sense signal line, and apply a driving voltage to each driving TFT (120) and each dummy driving TFT (220) through a driving voltage line;
a data driver configured to apply a data voltage to each scan TFT (130) and each dummy scan TFT (230) through a data line, and apply a display reference voltage or a sensing precharging voltage to each sense TFT (140) and each dummy sense TFT (240) through a reference voltage line;
a timing controller configured to control an operation mode of the data driver and the gate driver;
and
a plurality of bridge lines (180) extending from respective portions of the anode electrodes (212) of the dummy organic light emitting diodes, the bridge lines (180) being arranged in the plurality of pixel areas;
wherein the bridge line corresponding to a defective pixel area on the last horizontal line connects an anode electrode (112) of an organic light emitting diode (110) in the defective pixel area to an anode electrode (212) of a corresponding dummy organic light emitting diode (210) in a corresponding dummy pixel area;
wherein in the defective pixel area, the driving TFT (120) is unconnected with the driving voltage line to which the dummy driving TFT (220) of the corresponding dummy pixel circuit is connected, the scan TFT (130) is unconnected with the driving TFT (120), and the sense TFT (140) is unconnected with the driving TFT (120);
the method comprising:
when an error occurs in pixel areas formed at the outermost portion of the active area of the display device, sharing a signal that is applied to anode electrodes of two pixels which are vertically adjacent to each other so as to repair the error.

8. The method of claim 7, further comprising: supplying an output signal of a pixel circuit in a dummy pixel area of the plurality of dummy pixel areas to an anode electrode (112) of a corresponding defective pixel area of the plurality of pixel areas formed on the last horizontal line through a corresponding bridge line (180).

## Patentansprüche

1. Eine organische lichtemittierende Anzeige-Vorrichtung, aufweisend:
eine Vielzahl von Treiberspannungsleitungen, eine Vielzahl von Datenleitungen, und eine Vielzahl von Referenzspannungsleitungen, die jeweils in einer vertikalen Richtung ausgebildet sind;
eine Vielzahl von Gate-Leitungen und eine Vielzahl von Abtast-Signalleitungen, die jeweils in einer horizontalen Richtung ausgebildet sind;
eine Vielzahl von Pixelgebieten, die ein Emissionsgebiet (EA) und ein Pixel-Schaltungsgebiet enthalten, wobei die Vielzahl von Pixelgebieten konfiguriert sind, Licht von dem Emissionsgebiet (EA) zu emittieren, wobei das Emissionsgebiet (EA) eine Vielzahl von organischen lichtemittierenden Dioden (110) aufweist, die angepasst sind, Licht zu emittieren, und das Pixel-Schaltungsgebiet eine Vielzahl von Pixel-Schaltungen zur Kontrolle der Lichtemission von dem Emissionsgebiet (EA) aufweist, wobei jede Pixel-Schaltung einen Treiber-TFT (120), der konfiguriert ist, die Lieferung eines Datenstroms zu einer assoziierten organischen lichtemittierenden Diode (110) zu steuern, einen Scan-TFT (130), der konfiguriert ist, das Einschalten des Treiber-TFTs (120) zu steuern, und einen Abtast-TFT (140), der konfiguriert ist, das Abtasten des Datenstroms, der zu der assoziierten organischen lichtemittierenden Diode (110) geliefert wird, zu kontrollieren, aufweist, wobei in jeder Pixel-Schaltung eine Source-Elektrode eines Treiber-TFTs (120) mit einer Treiberspannungsleitung verbunden ist, eine Drain-Elektrode des Treiber-TFTs (120) mit einer Anodenelektrode (112) einer assoziierten organischen lichtemittieren Diode (110) verbunden ist, eine Gate-Elektrode des Treiber-TFTs (120) mit einer Drain-Elektrode eines Scan-TFTs (130) der Pixel-Schaltung verbunden ist, eine Gate-Elektrode des Scan-TFTs (130) mit einer Gate-Leitung verbunden ist, eine Source-Elektrode des Scan-TFTs (130) mit einer Datenleitung verbunden ist, eine Gate-Elektrode eines Abtast-TFTs (140) der Pixel-Schaltung mit einer Abtast-Signalleitung verbunden ist, eine Drain-Elektrode des Abtast-TFTs (140) mit einer Drain-Elektrode des Treiber-TFTs (120) verbunden ist, eine Source-Elektrode des Abtast-TFTs (140) mit einer Referenzspannungsleitung verbunden ist, und ein Speicherkondensator (Cst) zwischen die Gate-Elektrode des Treiber-TFTs (120) und die Drain-Elektrode des Treiber-TFTs (120) geschaltet ist;
eine Vielzahl von Dummy-Pixelgebieten, die vertikal benachbart zu einer Vielzahl von Pixelgebieten ausgebildet sind, die in einem äußersten Teilbereich eines aktiven Gebiets der Anzeige-Vorrichtung in einer letzten horizontalen Zeile ausgebildet sind,
wobei jedes Dummy-Pixelgebiet ein Nicht-Emissionsgebiet und ein Dummy-Pixel-Schaltungsgebiet aufweist, wobei die
Vielzahl von Dummy-Pixelgebieten angepasst sind, kein Licht zu emittieren, wobei das Nicht-Emissionsgebiet eine Vielzahl von organischen lichtemittierenden Dummy-Dioden (210) aufweist, wobei jede eine Anodenelektrode (212) enthält, wobei die organischen lichtemittierenden Dummy-Dioden (210) ohne eine organische Emissionssicht ausgebildet sind und angepasst sind, kein Licht zu emittieren, und wobei das
Dummy-Pixel-Schaltungsgebiet
eine Vielzahl von Dummy-Pixel-Schaltungen aufweist, wobei jede Dummy-Pixel-Schaltung einen Dummy-Treiber-TFT (220), der konfiguriert ist, die Lieferung eines Datenstroms an eine assoziierte organische lichtemittierende Dummy-Diode (210) zu steuern, einen Dummy-Scan-TFT (230), der konfiguriert ist, das Einschalten des Dummy-Treiber-TFTs (220) zu steuern, und einen Dummy-Abtast-TFT (240), der konfiguriert ist, das Abtasten des Datenstroms, der zu der assoziierten organischen lichtemittierenden Dummy-Diode (210) geliefert wird, zu steuern, aufweist, wobei in jeder Dummy-Pixel-Schaltung eine Source-Elektrode eines Dummy-Treiber-TFTs (220) mit der Treiberspannungsleitung verbunden ist, mit welcher die Source-Elektrode des Treiber-TFTs (120) einer assoziierten Pixelschaltung, die vertikal benachbart zu der Dummy-Pixel-Schaltung positioniert ist, verbunden ist, eine Drain-Elektrode des Dummy Treiber-TFTs (220) mit einer Anodenelektrode (212) einer assoziierten organischen lichtemittieren Dummy-Diode (110) verbunden ist, eine Gate-Elektrode des Dummy-Treiber-TFTs (220) mit einer Drain-Elektrode eines Dummy-Scan-TFTs (230) verbunden ist, eine Gate-Elektrode des Dummy-Scan-TFTs (230) mit der Gate-Leitung verbunden ist, mit welcher die Gate-Elektrode des Scan-TFTs (130) der assoziierten Pixel-Schaltung verbunden ist, eine Source-Elektrode des Dummy-Scan-TFTs (230) mit der Datenleitung verbunden ist, mit welcher die Source-Elektrode des Scan-TFTs (130) der assoziierten Pixel-Schaltung verbunden ist, eine Gate-Elektrode eines Dummy-Abtast-TFTs (240) mit der Abtast-Signalleitung verbunden ist, mit welcher die Gate-Elektrode des Abtast-TFTs (140) der assoziierten Pixelschaltung verbunden ist, eine Drain-Elektrode des Dummy-Abtast-TFTs (240) mit der Drain-Elektrode des Dummy-Treiber-TFTs (220) verbunden ist, eine Source-Elektrode des Dummy-Abtast-TFTs (240) mit der Referenzspannungsleitung verbunden ist, mit welcher die Source-Elektrode des Abtast-TFTs (140) der assoziierten Pixel-Schaltung verbunden ist, und ein
Dummy-Speicherkondensator ist zwischen die Gate-Elektrode des Dummy-Treiber-TFTs (220) und die Drain-Elektrode des Dummy-Treiber-TFTs (220) geschaltet;
einen Gate-Treiber, der konfiguriert ist, ein Scansignal an jeden Scan-TFT (130) und an jeden Dummy-Scan-TFT (230) über eine Gate-Leitung anzulegen, ein Abtast-Signal an jeden Abtast-TFT (140) und an jeden Dummy-Abtast-TFT (240) über eine Abtast-Signalleitung anzulegen, und eine Treiberspannung an jeden Treiber-TFT (120) und an jeden Dummy-Treiber-TFT (220) über eine Treiberspannungsleitung anzulegen;
einen Daten-Treiber, der konfiguriert ist, eine Datenspannung an jeden Scan-TFT (130) und an jeden Dummy-Scan-TFT (230) über eine Datenleitung anzulegen, und eine Anzeige-Referenzspannung oder eine Abtast-Vorladespannung an jeden Abtast-TFT (140) und an jeden Dummy-Abtast-TFT (240) über eine Referenzspannungsleitung anzulegen;
einen Timing-Controller, der konfiguriert ist, einen Betriebsmodus des Daten-Treibers und des Gate-Treibers zu steuern;
und
eine Vielzahl von Brückenleitungen (180), die sich ausgehend von jeweiligen Teilbereichen der Anodenelektroden (212) der organischen lichtemittierenden Dummy-Dioden erstrecken, wobei die Brückenleitungen (180) in der Vielzahl von Pixelgebieten angeordnet sind;
wobei die Brückenleitungen, die zu einem defekten Pixelgebiet in der letzten Zeile korrespondieren, eine Anodenelektrode (112) einer organischen lichtemittierenden Diode (110) in dem defekten Pixelgebiet mit einer Anodenelektrode (212) einer korrespondierenden organischen lichtemittierenden Dummy-Diode (210) in einem korrespondierenden Dummy-Pixelgebiet verbindet;
wobei in dem defekten Pixelgebiet der Treiber-TFT (120) nicht mit der TreiberSpannungsleitung verbunden ist, mit welcher der Dummy-Treiber-TFT (220) der korrespondierenden Dummy-Pixel-Schaltung verbunden ist, der Scan-TFT (130) nicht mit dem Treiber-TFT (120) verbunden ist und der Abtast-TFT (140) nicht mit dem Treiber-TFT (120) verbunden ist.

2. Die organische lichtemittierende Anzeige-Vorrichtung gemäß Anspruch 1, wobei:
jede Brückenleitung (180) sich von einer Länge einer Anodenelektrode (212), die in jedem Dummy-Pixelgebiet ausgebildet ist, erstreckt, wobei jede Brückenleitung (180) in jedem korrespondierendem Pixelgebiet, das in der letzten horizontalen Zeile ausgebildet ist, eine Gate-Elektrode (156) eines Treiber-TFTs (120) überlappt, wobei die organische lichtemittierende Anzeige-Vorrichtung ferner aufweist:
ein Schweißteil (160) in dem defekten Pixelgebiet, das mit einer korrespondierenden Brückenleitung (180) und der Gate-Elektrode (156) des Treiber-TFTs (120) des defekten Pixelgebiets verbunden ist, wobei das Schweißteil (160) konfiguriert ist, eine elektrische Verbindung zwischen der korrespondierenden Brückenleitung (180) und der Gate-Elektrode (156) bereitzustellen.

3. Die organische lichtemittierende Anzeige-Vorrichtung gemäß einem der Ansprüche 1 bis 2, ferner aufweisend:
einen Farbfilter (157), der in jedem der Pixelgebiete, die in der letzten horizontalen Zeile ausgebildet sind, über einer Passivierungsschicht (155) und unter einer korrespondierenden Brückenleitung (180) ausgebildet ist.

4. Die organische lichtemittierende Anzeige-Vorrichtung gemäß einem der Ansprüche 1 bis 3, wobei eine Anodenelektrode (112) in dem defekten Pixelgebiet der Vielzahl von Pixelgebieten, das in der letzten horizontalen Zeile ausgebildet ist, mit einer Anodenelektrode (212) eines korrespondierenden Dummy-Pixelgebiets über eine korrespondierende Brückenleitung (180) und eine Metallschicht einer Pixel-Schaltung in dem defekten Pixelgebiet verbunden ist, wobei die Metallschicht mit der Anodenelektrode (112) in dem defekten Pixelgebiet verbunden ist.

5. Die organische lichtemittierende Anzeige-Vorrichtung gemäß einem der Ansprüche 1 bis 2, wobei:
der Treiber-TFT (120) jedes Pixelgebiets oder der Dummy-Treiber-TFT (220) jedes Dummy-Pixel-Gebiets aufweist:
eine untere Gate-Elektrode (151), die auf einem Substrat (101) ausgebildet ist;
eine Gate-Isolationsschicht (152), die ausgebildet ist, die untere Gate-Elektrode (151) zu bedecken;
eine Aktivschicht, die auf der Gate-Isolationsschicht (152) ausgebildet ist;
eine Ätzstopperschicht (155), die auf der Aktivschicht ausgebildet ist;
eine Source/Drain-Metallschicht (154), die auf der Ätzstopperschicht (153) ausgebildet ist;
eine Passivierungsschicht (155), die ausgebildet ist, die Source/Drain-Metallschicht (154) zu bedecken; und
eine obere Gate-Elektrode (156), die auf der Passivierungsschicht (155) ausgebildet ist;
einen Farbfilter (157), der in einer Öffnung des Pixelgebiets oder des Dummy-Pixelgebiets ausgebildet ist;
eine Planarisierungsschicht (158), die ausgebildet ist, die obere Gate-Elektrode (156) und den Farbfilter (157) zu bedecken; und
eine Anodenelektrode (112, 212), die auf der Planarisierungsschicht (158) ausgebildet ist.

6. Die organische lichtemittierende Anzeige-Vorrichtung gemäß einem der Ansprüche 1 bis 3, ferner aufweisend:
ein Schweißteil (160) in dem defekten Pixelgebiet, wobei das Schweißteil (160) eine korrespondierende Brückenleitung (180) mit einer Metallschicht (154) einer Pixel-Schaltung in dem defekten Pixelgebiet der Vielzahl von Pixelgebieten, das auf der letzten Horizontal-Leitung ausgebildet ist, verbindet, so dass eine elektrische Verbindung zwischen der Brückenleitung (180) und der Metallschicht (154) bereitgestellt ist; wobei
eine Anodenelektrode (112) des defekten Pixelgebiets mit einer Anodenelektrode (212) eines korrespondierenden Dummy-Pixelgebiets der Vielzahl von Dummy-Pixelgebieten über das Schweißteil (160), die Brückenleitung (180) und die Metallschicht (154) verbunden ist.

7. Ein Verfahren zur Reparatur einer organischen lichtemittierenden Anzeige-Vorrichtung, aufweisend:
eine Vielzahl von Treiberspannungsleitungen, eine Vielzahl von Datenleitungen, und eine Vielzahl von Referenzspannungsleitungen, die jeweils in einer vertikalen Richtung ausgebildet sind;
eine Vielzahl von Gate-Leitungen und ein Vielzahl von Abtast-Signalleitungen, die jeweils in einer horizontalen Richtung ausgebildet sind;
eine Vielzahl von Pixelgebieten, die ein Emissionsgebiet (EA) und ein Pixel-Schaltungsgebiet enthalten, wobei die Vielzahl von Pixelgebieten konfiguriert sind, Licht von dem Emissionsgebiet (EA) zu emittieren, wobei das Emissionsgebiet (EA) eine Vielzahl von organischen lichtemittierenden Dioden (110) aufweist, die angepasst sind, Licht zu emittieren, und das Pixel-Schaltungsgebiet eine Vielzahl von Pixel-Schaltungen zur Steuerung der Lichtemission von dem Emissionsgebiet (EA) aufweist, wobei jede Pixel-Schaltung einen Treiber-TFT (120), der konfiguriert ist, die Lieferung eines Datenstroms zu einer assoziierten organischen lichtemittierenden Diode (110) zu steuern, einen Scan-TFT (130), der konfiguriert ist, das Einschalten des Treiber-TFTs (120) zu steuern, und einen Abtast-TFT (140), der konfiguriert ist, das Abtasten des Datenstroms, der zu der assoziierten organischen lichtemittierenden Diode (110) geliefert wird, zu kontrollieren, aufweist, wobei in jeder Pixel-Schaltung eine Source-Elektrode eines Treiber-TFTs (120) mit einer Treiberspannungsleitung verbunden ist, eine Drain-Elektrode des Treiber-TFTs (120) mit einer Anodenelektrode (112) einer assoziierten organischen lichtemittieren Diode (110) verbunden ist, eine Gate-Elektrode des Treiber-TFTs (120) mit einer Drain-Elektrode eines Scan-TFTs (130) der Pixel-Schaltung verbunden ist, eine Gate-Elektrode des Scan-TFTs (130) mit einer Gate-Leitung verbunden ist, eine Source-Elektrode des Scan-TFTs (130) mit einer Datenleitung verbunden ist, eine Gate-Elektrode eines Abtast-TFTs (140) der Pixel-Schaltung mit einer Abtast-Signalleitung verbunden ist, eine Drain-Elektrode des Abtast-TFTs (140) mit einer Drain-Elektrode des Treiber-TFTs (120) verbunden ist, eine Source-Elektrode des Abtast-TFTs (140) mit einer Referenzspannungsleitung verbunden ist, und ein Speicherkondensator (Cst) zwischen die Gate-Elektrode des Treiber-TFTs (120) und die Drain-Elektrode des Treiber-TFTs (120) geschaltet ist;
eine Vielzahl von Dummy-Pixelgebieten, die vertikal benachbart zu einer Vielzahl von Pixelgebieten ausgebildet sind, die in einem äußersten Teilbereich des aktiven Gebiets der Anzeige-Vorrichtung in einer letzten horizontalen Zeile ausgebildet sind, wobei jedes Dummy-Pixelgebiet ein Nicht-Emissionsgebiet und ein Dummy-Pixel-Schaltungsgebiet aufweist, wobei die
Vielzahl von Dummy-Pixelgebieten angepasst ist, kein Licht zu emittieren, wobei das Nicht-Emissionsgebiet eine Vielzahl von organischen lichtemittierenden Dummy-Dioden (210) aufweist, die jeweils eine Anodenelektrode (212) enthalten, wobei die organischen lichtemittierenden Dummy-Dioden (210) ohne eine organische Emissionssicht ausgebildet sind und angepasst sind, kein Licht zu emittieren, und wobei das
Dummy-Pixel-Schaltungsgebiet
eine Vielzahl von Dummy-Pixel-Schaltungen aufweist, wobei jede Dummy-Pixel-Schaltung einen Dummy-Treiber-TFT (220), der konfiguriert ist, die Lieferung eines Datenstroms an eine assoziierte organische lichtemittierende Dummy-Diode (210) zu steuern, einen Dummy-Scan-TFT (230), der konfiguriert ist, das Einschalten des Dummy-Treiber-TFTs (220) zu steuern, und einen Dummy-Abtast-TFT (240), der konfiguriert ist, das Abtasten des Datenstroms, der zu der assoziierten organischen lichtemittierenden Dummy-Diode (210) geliefert wird, zu kontrollieren, aufweist, wobei in jeder Dummy-Pixel-Schaltung eine Source-Elektrode eines Dummy-Treiber-TFTs (220) mit der Treiberspannungsleitung verbunden ist, mit welcher die Source-Elektrode des Treiber-TFTs (120) einer assoziierten Pixelschaltung, die vertikal benachbart zu der Dummy-Pixel-Schaltung positioniert ist, verbunden ist, eine Drain-Elektrode des Dummy-Treiber-TFTs (220) mit einer Anodenelektrode (212) einer assoziierten organischen lichtemittieren Dummy-Diode (110) verbunden ist, eine Gate-Elektrode des Dummy-Treiber-TFTs (220) mit einer Drain-Elektrode eines Dummy-Scan-TFTs (230) verbunden ist, eine Gate-Elektrode des Dummy-Scan-TFTs (230) mit der Gate-Leitung verbunden ist, mit welcher die Gate-Elektrode des Scan-TFTs (130) der assoziierten Pixel-Schaltung verbunden ist, eine Source-Elektrode des Dummy-Scan-TFTs (230) mit der Datenleitung verbunden ist, mit welcher die Source-Elektrode des Scan-TFTs (130) der assoziierten Pixel-Schaltung verbunden ist, eine Gate-Elektrode eines Dummy-Abtast-TFTs (240) mit der Abtast-Signalleitung verbunden ist, mit welcher die Gate-Elektrode des Abtast-TFTs (140) der assoziierten Pixelschaltung verbunden ist, eine Drain-Elektrode des Dummy-Abtast-TFTs (240) mit der Drain-Elektrode des Dummy-Treiber-TFTs (220) verbunden ist, eine Source-Elektrode des Dummy-Abtast-TFTs (240) mit der Referenzspannungsleitung verbunden ist, mit welcher die Source-Elektrode des Abtast-TFTs (140) der assoziierten Pixel-Schaltung verbunden ist, und ein
Dummy-Speicherkondensator, der zwischen die Gate-Elektrode des Dummy-Treiber-TFTs (220) und die Drain-Elektrode des Dummy-Treiber-TFTs (220) geschaltet ist;
einen Gate-Treiber, der konfiguriert ist, ein Scansignal an jeden Scan-TFT (130) und an jeden Dummy-Scan-TFT (230) über eine Gate-Leitung anzulegen, ein Abtast-Signal an jeden Abtast-TFT (140) und an jeden Dummy-Abtast-TFT (240) über eine Abtast-Signalleitung anzulegen, und eine Treiberspannung an jeden Treiber-TFT (120) und an jeden Dummy-Treiber-TFT (220) über eine Treiberspannungsleitung anzulegen;
einen Daten-Treiber, der konfiguriert ist, eine Datenspannung an jeden Scan-TFT (130) und an jeden Dummy-Scan-TFT (230) über eine Datenleitung anzulegen, und eine Anzeige-Referenzspannung oder eine Abtast-Vorladespannung an jeden Abtast-TFT (140) und an jeden Dummy-Abtast-TFT (240) über eine Referenzspannungsleitung anzulegen;
einen Timing-Controller, der konfiguriert ist, einen Betriebsmodus des Daten-Treibers und des Gate-Treibers zu steuern;
und
eine Vielzahl von Brückenleitungen (180), die sich ausgehend von jeweiligen Teilbereichen der Anodenelektroden (212) der organischen lichtemittierenden Dummy-Dioden erstrecken, wobei die Brückenleitungen (180) in der Vielzahl von Pixelgebieten angeordnet sind;
wobei die Brückenleitungen, die zu einem defekten Pixelgebiet in einer letzten horizontalen Zeile korrespondieren, eine Anodenelektrode (112) einer organischen lichtemittierenden Diode (110) in dem defekten Pixelgebiet mit einer Anodenelektrode (212) einer korrespondierenden organischen lichtemittierenden Dummy-Diode (210) in einem korrespondierenden Dummy-Pixelgebiet verbindet;
wobei in dem defekten Pixelgebiet der Treiber-TFT (120) nicht mit der TreiberSpannungsleitung verbunden ist, mit welcher der Dummy-Treiber-TFT (220) der korrespondierenden Dummy-Pixel-Schaltung verbunden ist, der Scan-TFT (130) nicht mit dem Treiber-TFT (120) verbunden ist und der Abtast-TFT (140) nicht mit dem Treiber-TFT (120) verbunden ist;
das Verfahren aufweisend:
wenn ein Fehler in Pixelgebieten, die in dem äußersten Bereich des aktiven Gebiets der Anzeige-Vorrichtung ausgebildet sind, auftritt, gemeinsames Nutzen eines Signals, das an Anodenelektroden von zwei Pixeln angelegt ist, die vertikal benachbart zueinander sind, um den Fehler zu reparieren.

8. Das Verfahren gemäß Anspruch 7, ferner aufweisend: Lieferung eines Ausgangssignals einer Pixel-Schaltung in einem Dummy-Pixelgebiet der Vielzahl von Dummy-Pixelgebieten an eine Anodenelektrode (112) eines korrespondierenden defekten Pixelgebiets der Vielzahl von Pixelgebieten, das in der letzten horizontalen Zeile ausgebildet ist, über eine korrespondierende Brückenleitung (180).

## Revendications

1. Dispositif d'affichage électroluminescent organique comprenant :
une pluralité de lignes de tension de commande, une pluralité de lignes de données, et une pluralité de lignes de tension de référence respectivement formées dans une direction verticale ;
une pluralité de lignes de grille et une pluralité de lignes de signal de détection respectivement formées dans une direction horizontale ;
une pluralité de zones de pixels comprenant une zone d'émission (EA) et une zone de circuits de pixel, la pluralité de zones de pixels étant configurées pour émettre de la lumière à partir de la zone d'émission (EA), dans lequel la zone d'émission (EA) comprend une pluralité de diodes électroluminescentes organiques (110) conçues pour émettre de la lumière, et la zone de circuits de pixel comprend une pluralité de circuits de pixel pour commander l'émission de lumière à partir de la zone d'émission (EA), chaque circuit de pixel comprenant un TFT de commande (120) configuré pour commander la fourniture d'un courant de données à une diode électroluminescente organique (110) associée, un TFT de balayage (130) configuré pour commander la mise à l'état passant du TFT de commande (120), et un TFT de détection (140) configuré pour commander la détection du courant de données fourni à la diode électroluminescente organique (110) associée, dans lequel, dans chaque circuit de pixel, une électrode de source d'un TFT de commande (120) est connectée à une ligne de tension de commande, une électrode de drain du TFT de commande (120) est connectée à une électrode d'anode (112) d'une diode électroluminescente organique (110) associée, une électrode de grille du TFT de commande (120) est connectée à une électrode de drain d'un TFT de balayage (130) du circuit de pixel, une électrode de grille du TFT de balayage (130) est connectée à une ligne de grille, une électrode de source du TFT de balayage (130) est connectée à une ligne de données, une électrode de grille d'un TFT de détection (140) du circuit de pixel est connectée à une ligne de signal de détection, une électrode de drain du TFT de détection (140) est connectée à une électrode de drain du TFT de commande (120), une électrode de source du TFT de détection (140) est connectée à une ligne de tension de référence, et un condensateur de stockage (Cst) est connecté entre l'électrode de grille du TFT de commande (120) et l'électrode de drain du TFT de commande (120) ;
une pluralité de zones de pixels fictifs formées verticalement adjacentes à une pluralité de zones de pixels formées au niveau d'une partie la plus à l'extérieur d'une zone active du dispositif d'affichage sur une dernière ligne horizontale, dans lequel chaque zone de pixels fictifs comprend une zone non d'émission et une zone de circuits de pixel fictif, la pluralité de zones de pixels fictifs étant conçues pour ne pas émettre de lumière, dans lequel la zone non d'émission comprend une pluralité de diodes électroluminescentes organiques fictives (210) comprenant chacune une électrode d'anode (212), dans lequel les diodes électroluminescentes organiques fictives (210) sont formées sans couche d'émission organique et conçues pour ne pas émettre de lumière, et dans lequel la zone de circuits de pixel fictif comprend une pluralité de circuits de pixel fictif, chaque circuit de pixel fictif comprenant un TFT de commande fictif (220) configuré pour commander la fourniture d'un courant de données à une diode électroluminescente organique fictive (210) associée, un TFT de balayage fictif (230) configuré pour commander la mise à l'état passant du TFT de commande fictif (220), et un TFT de détection fictif (240) configuré pour commander la détection du courant de données fourni à la diode électroluminescente organique fictive (210) associée, dans lequel, dans chaque circuit de pixel fictif, une électrode de source d'un TFT de commande fictif (220) est connectée à la ligne de tension de commande à laquelle l'électrode de source du TFT de commande (120) d'un circuit de pixel associé positionné verticalement adjacent au circuit de pixel fictif est connectée, une électrode de drain du TFT de commande fictif (220) est connectée à une électrode d'anode (212) d'une diode électroluminescente organique fictive (110) associée, une électrode de grille du TFT de commande fictif (220) est connectée à une électrode de drain d'un TFT de balayage fictif (230), une électrode de grille du TFT de balayage fictif (230) est connectée à la ligne de grille à laquelle l'électrode de grille du TFT de balayage (130) du circuit de pixel associé est connectée, une électrode de source du TFT de balayage fictif (230) est connectée à la ligne de données à laquelle l'électrode de source du TFT de balayage (130) du circuit de pixel associé est connectée, une électrode de grille d'un TFT de détection fictif (240) est connectée à la ligne de signal de détection à laquelle l'électrode de grille du TFT de détection (140) du circuit de pixel associé est connectée, une électrode de drain du TFT de détection fictif (240) est connectée à l'électrode de drain du TFT de commande fictif (220), une électrode de source du TFT de détection fictif (240) est connectée à la ligne de tension de référence à laquelle l'électrode de source du TFT de détection (140) du circuit de pixel associé est connectée, et un condensateur de stockage fictif est connecté entre l'électrode de grille du TFT de commande fictif (220) et l'électrode de drain du TFT de commande fictif (220) ;
un dispositif de commande de grille configuré pour appliquer un signal de balayage à chaque TFT de balayage (130) et à chaque TFT de balayage fictif (230) par l'intermédiaire d'une ligne de grille, appliquer un signal de détection à chaque TFT de détection (140) et à chaque TFT de détection fictif (240) par l'intermédiaire d'une ligne de signal de détection, et appliquer une tension de commande à chaque TFT de commande (120) et à chaque TFT de commande fictif (220) par l'intermédiaire d'une ligne de tension de commande ;
un dispositif de commande de données configuré pour appliquer une tension de données à chaque TFT de balayage (130) et à chaque TFT de balayage fictif (230) par l'intermédiaire d'une ligne de données, et appliquer une tension de référence d'affichage ou une tension de précharge de détection à chaque TFT de détection (140) et à chaque TFT de détection fictif (240) par l'intermédiaire d'une ligne de tension de référence ;
un contrôleur de synchronisation configuré pour commander un mode de fonctionnement du dispositif de commande de données et du dispositif de commande de grille ;
et
une pluralité de lignes de pont (180) s'étendant de parties respectives des électrodes d'anode (212) des diodes électroluminescentes organiques fictives, les lignes de pont (180) étant agencées dans la pluralité de zones de pixels ;
dans lequel la ligne de pont correspondant à une zone de pixels défectueux sur la dernière ligne horizontale connecte une électrode d'anode (112) d'une diode électroluminescente organique (110) dans la zone de pixels défectueux à une électrode d'anode (212) d'une diode électroluminescente organique fictive (210) correspondante dans une zone de pixels fictifs correspondante ;
dans lequel, dans la zone de pixels défectueux, le TFT de commande (120) n'est pas connecté à la ligne de tension de commande à laquelle le TFT de commande fictif (220) du circuit de pixel fictif correspondant est connecté, le TFT de balayage (130) n'est pas connecté au TFT de commande (120), et le TFT de détection (140) n'est pas connecté au TFT de commande (120).

2. Dispositif d'affichage électroluminescent organique selon la revendication 1, dans lequel :
chaque ligne de pont (180) s'étend d'une longueur d'une électrode d'anode (212) formée dans chaque zone de pixels fictifs, dans lequel chaque ligne de pont (180) recouvre, dans chaque zone de pixels correspondante formée sur la dernière ligne horizontale, une électrode de grille (156) d'un TFT de commande (120), dans lequel le dispositif d'affichage électroluminescent organique comprend en outre :
une partie de soudage (160) dans la zone de pixels défectueux connectée à une ligne de pont (180) correspondante et à l'électrode de grille (156) du TFT de commande (120) de la zone de pixels défectueux, dans lequel la partie de soudage (160) est configurée pour réaliser une connexion électrique entre la ligne de pont (180) correspondante et l'électrode de grille (156).

3. Dispositif d'affichage électroluminescent organique selon l'une quelconque des revendications 1 et 2, comprenant en outre :
un filtre coloré (157) formé dans chacune des zones de pixels formées sur la dernière ligne horizontale au-dessus d'une couche de passivation (155) et au-dessous d'une ligne de pont (180) correspondante.

4. Dispositif d'affichage électroluminescent organique selon l'une quelconque des revendications 1 à 3, dans lequel une électrode d'anode (112) dans la zone de pixels défectueux de la pluralité de zones de pixels formées sur la dernière ligne horizontale est connectée à une électrode d'anode (212) d'une zone de pixels fictifs correspondante par l'intermédiaire d'une ligne de pont (180) correspondante et d'une couche métallique d'un circuit de pixel dans la zone de pixels défectueux, dans lequel la couche métallique est connectée à l'électrode d'anode (112) dans la zone de pixels défectueux.

5. Dispositif d'affichage électroluminescent organique selon l'une quelconque des revendications 1 et 2, dans lequel :
le TFT de commande (120) de chaque zone de pixels ou le TFT de commande fictif (220) de chaque zone de pixels fictifs comprend :
une électrode de grille inférieure (151) formée sur un substrat (101) ;
une couche isolante de grille (152) formée de manière à recouvrir l'électrode de grille inférieure (151) ;
une couche active formée sur la couche isolante de grille (152) ;
une couche d'arrêt de gravure (155) formée sur la couche active ;
une couche métallique source/drain (154) formée sur la couche d'arrêt de gravure (153) ;
une couche de passivation (155) formée de manière à recouvrir la couche métallique source/drain (154) ; et
une électrode de grille supérieure (156) formée sur la couche de passivation (155) ;
un filtre coloré (157) formé dans une ouverture de la zone de pixels ou de la zone de pixels fictifs ;
une couche de nivellement (158) formée de manière à recouvrir l'électrode de grille supérieure (156) et le filtre coloré (157) ; et
une électrode d'anode (112, 212) formée sur la couche de nivellement (158).

6. Dispositif d'affichage électroluminescent organique selon l'une quelconque des revendications 1 à 3, comprenant en outre :
une partie de soudage (160) dans la zone de pixels défectueux, la partie de soudage (160) connectant une ligne de pont (180) correspondante à une couche métallique (154) d'un circuit de pixel dans la zone de pixels défectueux de la pluralité de zones de pixels formées sur la dernière ligne horizontale pour réaliser une connexion électrique entre la ligne de pont (180) et la couche métallique (154) ; dans lequel
une électrode d'anode (112) de la zone de pixels défectueux est connectée à une électrode d'anode (212) d'une zone de pixels fictifs correspondante de la pluralité de zones de pixels fictifs par l'intermédiaire de la partie de soudage (160), de la ligne de pont (180) et de la couche métallique (154).

7. Procédé pour réparer un dispositif d'affichage électroluminescent organique comprenant :
une pluralité de lignes de tension de commande, une pluralité de lignes de données, et une pluralité de lignes de tension de référence respectivement formées dans une direction verticale ;
une pluralité de lignes de grille et une pluralité de lignes de signal de détection respectivement formées dans une direction horizontale ;
une pluralité de zones de pixels comprenant une zone d'émission (EA) et une zone de circuits de pixel, la pluralité de zones de pixels étant configurées pour émettre de la lumière à partir de la zone d'émission (EA), dans lequel la zone d'émission (EA) comprend une pluralité de diodes électroluminescentes organiques (110) conçues pour émettre de la lumière, et la zone de circuits de pixel comprend une pluralité de circuits de pixel pour commander l'émission de lumière à partir de la zone d'émission (EA), chaque circuit de pixel comprenant un TFT de commande (120) configuré pour commander la fourniture d'un courant de données à une diode électroluminescente organique (110) associée, un TFT de balayage (130) configuré pour commander la mise à l'état passant du TFT de commande (120), et un TFT de détection (140) configuré pour commander la détection du courant de données fourni à la diode électroluminescente organique (110) associée, dans lequel, dans chaque circuit de pixel, une électrode de source d'un TFT de commande (120) est connectée à une ligne de tension de commande, une électrode de drain du TFT de commande (120) est connectée à une électrode d'anode (112) d'une diode électroluminescente organique (110) associée, une électrode de grille du TFT de commande (120) est connectée à une électrode de drain d'un TFT de balayage (130) du circuit de pixel, une électrode de grille du TFT de balayage (130) est connectée à une ligne de grille, une électrode de source du TFT de balayage (130) est connectée à une ligne de données, une électrode de grille d'un TFT de détection (140) du circuit de pixel est connectée à une ligne de signal de détection, une électrode de drain du TFT de détection (140) est connectée à une électrode de drain du TFT de commande (120), une électrode de source du TFT de détection (140) est connectée à une ligne de tension de référence, et un condensateur de stockage (Cst) est connecté entre l'électrode de grille du TFT de commande (120) et l'électrode de drain du TFT de commande (120) ;
une pluralité de zones de pixels fictifs formées verticalement adjacentes à une pluralité de zones de pixels formées au niveau d'une partie la plus à l'extérieur d'une zone active du dispositif d'affichage sur une dernière ligne horizontale, dans lequel chaque zone de pixels fictifs comprend une zone non d'émission et une zone de circuits de pixel fictif, la pluralité de zones de pixels fictifs étant conçues pour ne pas émettre de lumière, dans lequel la zone non d'émission comprend une pluralité de diodes électroluminescentes organiques fictives (210) comprenant chacune une électrode d'anode (212), dans lequel les diodes électroluminescentes organiques fictives (210) sont formées sans couche d'émission organique et conçues pour ne pas émettre de lumière, et dans lequel la zone de circuits de pixel fictif comprend une pluralité de circuits de pixel fictif, chaque circuit de pixel fictif comprenant un TFT de commande fictif (220) configuré pour commander la fourniture d'un courant de données à une diode électroluminescente organique fictive (210) associée, un TFT de balayage fictif (230) configuré pour commander la mise à l'état passant du TFT de commande fictif (220), et un TFT de détection fictif (240) configuré pour commander la détection du courant de données fourni à la diode électroluminescente organique fictive (210) associée, dans lequel, dans chaque circuit de pixel fictif, une électrode de source d'un TFT de commande fictif (220) est connectée à la ligne de tension de commande à laquelle l'électrode de source du TFT de commande (120) d'un circuit de pixel associé positionné verticalement adjacent au circuit de pixel fictif est connectée, une électrode de drain du TFT de commande fictif (220) est connectée à une électrode d'anode (212) d'une diode électroluminescente organique fictive (110) associée, une électrode de grille du TFT de commande fictif (220) est connectée à une électrode de drain d'un TFT de balayage fictif (230), une électrode de grille du TFT de balayage fictif (230) est connectée à la ligne de grille à laquelle l'électrode de grille du TFT de balayage (130) du circuit de pixel associé est connectée, une électrode de source du TFT de balayage fictif (230) est connectée à la ligne de données à laquelle l'électrode de source du TFT de balayage (130) du circuit de pixel associé est connectée, une électrode de grille d'un TFT de détection fictif (240) est connectée à la ligne de signal de détection à laquelle l'électrode de grille du TFT de détection (140) du circuit de pixel associé est connectée, une électrode de drain du TFT de détection fictif (240) est connectée à l'électrode de drain du TFT de commande fictif (220), une électrode de source du TFT de détection fictif (240) est connectée à la ligne de tension de référence à laquelle l'électrode de source du TFT de détection (140) du circuit de pixel associé est connectée, et un condensateur de stockage fictif est connecté entre l'électrode de grille du TFT de commande fictif (220) et l'électrode de drain du TFT de commande fictif (220) ;
un dispositif de commande de grille configuré pour appliquer un signal de balayage à chaque TFT de balayage (130) et à chaque TFT de balayage fictif (230) par l'intermédiaire d'une ligne de grille, appliquer un signal de détection à chaque TFT de détection (140) et à chaque TFT de détection fictif (240) par l'intermédiaire d'une ligne de signal de détection, et appliquer une tension de commande à chaque TFT de commande (120) et à chaque TFT de commande fictif (220) par l'intermédiaire d'une ligne de tension de commande ;
un dispositif de commande de données configuré pour appliquer une tension de données à chaque TFT de balayage (130) et à chaque TFT de balayage fictif (230) par l'intermédiaire d'une ligne de données, et appliquer une tension de référence d'affichage ou une tension de précharge de détection à chaque TFT de détection (140) et à chaque TFT de détection fictif (240) par l'intermédiaire d'une ligne de tension de référence ;
un contrôleur de synchronisation configuré pour commander un mode de fonctionnement du dispositif de commande de données et du dispositif de commande de grille ;
et
une pluralité de lignes de pont (180) s'étendant de parties respectives des électrodes d'anode (212) des diodes électroluminescentes organiques fictives, les lignes de pont (180) étant agencées dans la pluralité de zones de pixels ;
dans lequel la ligne de pont correspondant à une zone de pixels défectueux sur la dernière ligne horizontale connecte une électrode d'anode (112) d'une diode électroluminescente organique (110) dans la zone de pixels défectueux à une électrode d'anode (212) d'une diode électroluminescente organique fictive (210) correspondante dans une zone de pixels fictifs correspondante ;
dans lequel, dans la zone de pixels défectueux, le TFT de commande (120) n'est pas connecté à la ligne de tension de commande à laquelle le TFT de commande fictif (220) du circuit de pixel fictif correspondant est connecté, le TFT de balayage (130) n'est pas connecté au TFT de commande (120), et le TFT de détection (140) n'est pas connecté au TFT de commande (120) ;
le procédé comprenant :
lorsqu'une erreur se produit dans des zones de pixels formées au niveau de la partie la plus à l'extérieur de la zone active du dispositif d'affichage, le partage d'un signal qui est appliqué aux électrodes d'anode de deux pixels qui sont verticalement adjacents l'un à l'autre de manière à réparer l'erreur.

8. Procédé selon la revendication 7, comprenant en outre : la fourniture d'un signal de sortie d'un circuit de pixel dans une zone de pixels fictifs de la pluralité de zones de pixels fictifs à une électrode d'anode (112) d'une zone de pixels défectueux correspondante de la pluralité de zones de pixels formées sur la dernière ligne horizontale par l'intermédiaire d'une ligne de pont (180) correspondante.
